# EUROPEAN PATENT APPLICATION

(11) **EP 4 686 102 A1**
(43) Date of publication of application: **28.01.2026**
(21) Application number: 25190382.9
(22) Date of filing: 18.07.2025
(51) Int. Cl.: H03L 7/08

(54) **CLOCK DUTY CYCLE CALIBRATION CIRCUIT, METHOD, AND CLOCK MULTIPLIER CIRCUIT**

(30) Priority: 25.07.2024 CN 202411012771
(71) Applicant: Amlogic (Shanghai) Co., Ltd., Shanghai 201315 (CN)
(72) Inventor: ZOU, Weihua, Shanghai (CN); SHI, Ming, Shanghai (CN)
(74) Representative: Maiwald GmbH

(57) **Abstract**

A clock duty cycle calibration circuit, method, and clock multiplier circuit, wherein the clock duty cycle calibration circuit uses the calibration control cell to perform a first sampling process on the delay-matched clock signal using the first feedback clock signal when the phase-locked loop cell is in the first locked state, can acquire a first sampled signal that used to instruct the relationship between the actual duty cycle of the calibration clock signal and the target duty cycle, then the calibration control cell generates the first calibration control signal according to the first sampled signal, thereby enable the duty cycle calibration cell to maintain the duty cycle of the calibration control signal at the target duty cycle according to the first calibration control signal, that can overcome duty cycle offset caused by operating temperature, which helps improve the accuracy of the generated calibration clock signal.

## Description

### CROSS-REFERENCE TO RELATED APPLICATIONS

This application claims priority to Chinese Patent Application No.202411012771.2, filed on July. 25, 2024.

### TECHNICAL FIELD

The disclosure relates to the technical field of circuits, and in particular to a clock duty cycle calibration circuit, method, and clock multiplier circuit.

### BACKGROUND

In the field of wireless communication, frequency synthesizers based on phase-locked loop structures are widely used to generate oscillation signals, wherein, the phase noise performance of the oscillation signals affects the quality of the communication signals directly.

Currently, the main approach is to increase the frequency of the phase-locked loop reference clock signal through clock multiplier technology, thereby improving the phase noise performance of the phase-locked loop.

Therefore, it is a pressing issue that how to improve the stability of the clock duty cycle of the reference clock signal in the duty cycle calibration circuit, reduce external interference, and thereby enhancing the output accuracy of the clock duty cycle calibration circuit.

### SUMMARY

The problem solved by the embodiments of the disclosure is to provide a clock duty cycle calibration circuit, clock duty cycle calibration method, and clock multiplier circuit, that can calibrate the duty cycle of the calibration clock signal to the target duty cycle, thereby improving the accuracy of the generated calibration clock signal.

To solve the above technical problems, the embodiment of the disclosure provides a clock duty cycle calibration circuit, comprising:
a duty cycle calibration cell, configured to perform the first duty cycle calibration processing on the input clock signal according to the first calibration control signal, to maintain the duty cycle of the calibration control signal at the target duty cycle;
a delay matching cell, configured to perform delay matching processing on the calibration clock signal, to acquire a delay-matched clock signal, the first edge of the delay-matched clock signal is aligned with the first edge of the calibration clock signal, and the delay-matched clock signal has the same duty cycle as the calibration control signal;
a signal frequency multiplier cell, configured to perform frequency multiplication processing on the calibration clock signal, to acquire the corresponding frequency-multiplied clock signal, the first edge of the frequency-multiplied clock signal is aligned with the first edge of the calibration clock signal, and the frequency of the frequency-multiplied clock signal is a multiple of the frequency of the calibration clock signal;
a phase-locked loop cell, configured to perform the first phase-locked processing on the frequency-multiplied clock signal ,to acquire the first oscillating clock signal; and perform the first frequency division processing on the first oscillating clock signal ,to acquire the first feedback clock signal; Wherein, when the phase-locked loop cell is in the first locked state, the first edge of the first feedback clock signal is aligned with the first edge of the frequency-multiplied clock signal, and the first feedback clock signal has the same frequency as the frequency-multiplied clock signal;
a calibration control cell, configured to, when the phase-locked loop cell is in the locked state, perform a first sampling processing on delay-matched clock signal using the first feedback clock signal, to acquire the first sampled signal; According to the first sampled signal, generate the first calibration control signal.

Optionally, the duty cycle calibration cell comprises:
a first delay block, configured to perform the first delay processing on the input clock signal, to acquire a first delay clock signal;
a first OR operation block, configured to perform OR operations processing on the input clock signal and the first delay clock signal, to acquire the summed clock signal;
a first inverter, configured to perform inversion processing on the summed clock signal ,to acquire the inverted signal of the summed clock signal;
a second delay block, configured to perform a second delay processing on the inverted signal of the summed clock signal according to the first calibration control signal, to acquire a second delay clock signal;
a second OR operation block, configured to perform OR operation processing on the inverted signal of the summed clock signal and the second delay clock signal, to acquire the calibration clock signal.

Optionally, the signal frequency multiplier cell comprises:
a third delay block, configured to perform a third delay processing on the calibration clock signal, to acquire a third delay clock signal;
a XOR operation block, configured to perform XOR operation processing on the calibration clock signal and the third delay clock signal, to acquire the frequency-multiplied clock signal.

Optionally, the phase-locked loop cell comprises:
a phase-frequency detector block, configured to acquire the first phase difference signal according to the phase difference between the frequency-multiplied clock signal and the first feedback clock signal;
a charge pump block, configured to convert the first phase difference signal into a first current signal;
a loop filter block, configured to perform low-pass filter processing on the first current signal ;
a voltage-controlled oscillator block, configured to acquire the first oscillation clock signal according to the first current signal;
a first frequency divider block, configured to perform the first frequency division processing on the first oscillating clock signal, to acquire the first feedback clock signal.

Optionally, the first frequency divider block comprises at least one of:
a first frequency divider, configured to perform the first sub frequency division processing on the first oscillating clock signal, to acquire the first frequency-divided signal;
a second frequency divider, configured to perform the second sub frequency division processing on the first frequency-divided signal, to acquire the first feedback clock signal.

Optionally, the first frequency divider is a step frequency divider with a step value of 1/2 ^{n,} the second frequency divider is a frequency divider-by-2, wherein n is an integer greater than or equal to 0.

Optionally, the first calibration control signal comprises multiple fine adjustment step control signals one-to-one corresponding to multiple fine adjustment steps;
the calibration control cell, configured to, when the phase-locked loop cell is in the first locked state, generate a fine adjustment step control signal corresponding to the corresponding fine adjustment step according to the first sampled signal and output to the duty cycle calibration cell.

Optionally, the calibration control cell comprises:
a sampling block, configured to, when the phase-locked loop cell is in the first locked state, perform the first sampling processing on the delay-matched clock signal using the first feedback clock signal, to acquire the sampled signal;
a control block, configured to generate the first calibration control signal according to the first sampled signal.

Optionally, the sampling block comprises:
a first D Flip-Flop, configured to, when the second edge of the first feedback clock signal arrives, perform a first sub sampling processing on the delay-matched clock signal, to acquire the first sub sampled signal; a second D Flip-Flop, configured to, after acquiring the first sub sampled signal and when the first edge of the first feedback clock signal arrives, perform a second sub sampling processing on the delay-matched clock signal, to acquire the second sub sampled signal; a third D Flip-Flop, configured to, after acquiring the second sub sampled signal and when the second edge of the first feedback clock signal arrives, transmit the first sub sampled signal to the control block; a fourth D Flip-Flop, configured to, after acquiring the second sub sampled signal and when the second edge of the first feedback clock signal arrives, transmit the second sub sampled signal to the control block;

The control block, configured to generate the first calibration control signal according to the first sub sampled signal and the second sub sampled signal.

Optionally, the first edge is the rising edge, and the second edge is the falling edge.

Optionally, the control block, configured to acquire the sampled values of the first sub sampled signal and the sampled values of the second sub sampled signal according to a preset first control period; If the sampled values of the first sub sampled signal are all the first sampled value and the sampled values of the second sub sampled signal are all the second sampled value within the first control period, then generate a first calibration control signal to instruct the duty cycle calibration cell to increase the duty cycle of the calibration clock signal; If the sampled values of the first sub sampled signal are all the first sampled value and the sampled values of the second sub sampled signal are all the third value within the first control period, then generate a first calibration control signal to instruct the duty cycle calibration cell to reduce the duty cycle of the calibration clock signal.

Optionally, the control block comprises a digital frequency multiplier with a low-pass filter.

Optionally, the phase-locked loop cell, configured to perform the third frequency division processing on the first oscillating clock signal, to acquire the third frequency-divided signal;
The calibration control cell, configured to perform a fourth delay processing on the delay-matched clock signal, to acquire the first timing control signal according to the third frequency-divided signal, the frequency of the first timing control signal is higher than the frequency of the first feedback clock signal, and the phase of the first timing control signal lags behind the phase of the first feedback clock signal; According to the first timing control signal, control the output timing of the first calibration control signal.
Optionally, the phase-locked loop cell further comprising: a third frequency divider block, configured to perform the third frequency division processing on the first oscillating clock signal, to acquire the third frequency-divided signal;
The calibration control cell further comprising: a timing control block, configured to perform a fourth delay processing on the delay-matched clock signal, to acquire the first timing control signal, the frequency of the first timing control signal is higher than the frequency of the first feedback clock signal, and the phase of the first timing control signal lags behind the phase of the first feedback clock signal;
The control block, configured to control the output timing of the first calibration control signal according to the first timing control signal.

Optionally, the timing control block comprises a time delay cell.
Optionally, the duty cycle calibration cell, further configured to, before performing a first duty cycle calibration processing on the input clock signal according to the first calibration control signal to maintain the duty cycle of the calibration control signal at the target duty cycle, perform a second duty cycle calibration processing on the input clock signal according to the second calibration control signal until the duty cycle of the calibration clock signal reaches the target duty cycle;
The phase-locked loop cell, further configured to perform a second phase-locking processing on the calibration clock signal ,to acquire a second oscillation clock signal; and perform a second frequency division process on the second oscillation clock signal ,to acquire a second feedback clock signal; wherein, when the phase-locked loop cell is in the second locked state, the first edge of the second feedback clock signal is aligned with the first edge of the calibration clock signal, and the second feedback clock signal has the target duty cycle;
The calibration control cell, further configured to, when the phase-locked loop cell is in the second locked state, perform a second sampling process on the delay-matched clock signal using the second feedback clock signal, to acquire a second sampled signal; According to the second sampled signal, generate the second calibration control signal.

Optionally, the calibration control cell, further configured to, during the process of performing a second duty cycle calibration processing on the input clock signal according to the second calibration control signal until the duty cycle of the calibration clock signal reaches the target duty cycle, generate a reference selection control signal with a first logic level; then after performing a second duty cycle calibration processing on the input clock signal according to the second calibration control signal until the duty cycle of the calibration clock signal reaches the target duty cycle, convert the logic level of the reference selection control signal from the first logic level to the second logic level;
The clock duty cycle calibration circuit further comprises: a data strobe cell, configured to, when receiving a reference selection control signal with a first logic level, select and output the calibration clock signal to the phase-locked loop cell; and when receiving a reference selection control signal with a second logic level, select and output the frequency-multiplied clock signal to the phase-locked loop cell;
The phase-locked loop cell further comprising: a first data strobe block, configured to, when receiving a reference selection control signal with a first logic level, select and output the first feedback clock signal to the calibration control cell; and when receiving a reference selection control signal with a first logic level, select and output the second feedback clock signal to the calibration control cell;

Optionally, the data strobe cell comprises multiplexer.

Optionally, first data strobe block comprises multiplexer.

Optionally, the second calibration control signal comprises multiple coarse adjustment step control signals one-to-one corresponding to multiple coarse adjustment steps and multiple fine adjustment step control signals one-to-one corresponding to multiple fine adjustment steps, and the step interval between adjacent coarse adjustment step is greater than the step interval between adjacent fine adjustment step;
The calibration control cell, configured to generate a coarse adjustment step control signal corresponding to the coarse adjustment step according to the second sampled signal and output to the duty cycle calibration cell, until the duty cycle of the calibration clock signal oscillates back and forth near the target duty cycle; and further configured to, after the duty cycle of the calibration clock signal oscillates back and forth around the target duty cycle, generate a coarse adjustment step control signal corresponding to the corresponding fine adjustment step according to the second sampled signal and output to the duty cycle calibration cell , until the duty cycle of the calibration clock signal reaches the target duty cycle.

Optionally, the calibration control cell, further configured to, when performing a second duty cycle calibration processing on the input clock signal according to the second calibration control signal until the duty cycle of the calibration clock signal reaches the target duty cycle, acquire the corresponding coarse adjustment calibration control signal and the corresponding fine adjustment calibration control signal and store; further configured to, when receiving a wake-up signal, transmit the stored coarse adjustment calibration control signal and the fine adjustment calibration control signal to the duty cycle calibration cell;
The duty cycle calibration cell, further configured to, when receiving the coarse adjustment calibration control signal and the fine adjustment calibration control signal sent by the calibration control cell, calibrate the duty cycle of the calibration clock signal to the target duty cycle according to the received coarse adjustment calibration control signal and fine adjustment calibration control signal;

Optionally, the first the oscillation clock signal and the second the oscillation clock signal have the same frequency.

Optionally, the clock duty cycle calibration circuit, further comprises:
a signal selection cell, configured to, before performing a second duty cycle calibration processing on the input clock signal according to the second calibration control signal until the duty cycle of the calibration clock signal reaches the target duty cycle, select and output the initial clock signal with a duty cycle greater than the target duty cycle or the inverted signal of the initial clock signal according to the duty cycle selection control signal as the input clock signal ;
The delay matching cell, further configured to perform initial delay matching processing on the initial clock signal, to acquire an initial delay-matched signal, the first edge of the initial delay-matched clock signal is aligned with the first edge of the initial clock signal, and the delay-matched clock signal has the same duty cycle as the initial clock signal;
The phase-locked loop cell, further configured to perform an initial phase-locked processing on the initial clock signal ,to acquire the initial oscillation clock signal, and perform initial frequency division processing on the initial oscillation clock signal ,to acquire the initial feedback clock signal; Wherein, when the phase-locked loop cell is in the initial locked state, the first edge of the initial feedback clock signal is aligned with the first edge of the initial delay-matched clock signal and has the target duty cycle;
The calibration control cell, further configured to, when the phase-locked loop cell is in the initial locked state, perform initial sampling processing on the initial delay-matched clock signal using the initial feedback clock signal, to acquire an initial sampled signal, the initial sampled signal is used to instruct the relationship between the duty cycle of the initial clock signal and the target duty cycle; According to the initial sampled signal, generate the duty cycle selection control signal.

Optionally, the calibration control cell, further configured to, before generating the duty cycle selection control signal, generate a mode selection control signal with a first logic level; After generating the duty cycle selection control signal, convert the logic level of the mode selection control signal from the first logic level to the second logic level;
The duty cycle calibration cell, configured to, when the mode selection control signal has a second logic level, perform the second duty cycle calibration processing on the input clock signal according to the second calibration control signal, until the duty cycle of the calibration clock signal reaches the target duty cycle; and further configured to, when the mode selection control signal has a second logic level, perform a first duty cycle calibration processing on the input clock signal according to the first calibration control signal, to maintain the duty cycle of the calibration clock signal at the target duty cycle; and before performing a second duty cycle calibration processing on the input clock signal when the mode selection control signal has a first logic level and according to the second calibration control signal, until before the duty cycle of the calibration control signal reaches the target duty cycle, pass the initial clock signal through to the phase-locked loop cell and the delay matching cell.

Optionally, the signal selection cell, configured to, when the duty cycle selection control signal has a first logic level, select and output the initial clock signal as the input clock signal; and when the duty cycle selection control signal has a second logic level, select and output the inverted signal of the initial clock signal as the input clock signal;
The calibration control cell, further configured to, when determining that the duty cycle of the initial clock signal is greater than the target duty cycle and the duty cycle selection control signal has the second logic level, convert the logic level of the duty cycle selection control signal from the first logic level to the second logic level, and when waiting for the phase-locked loop cell reenters the initial locked state, convert the logic level of the mode selection control signal from the first logic level to the second logic level.

Optionally, the signal selection cell comprising:
The third inverter, configured to perform an inversion processing on the initial clock signal, to acquire an inverted signal of the initial clock signal;
a second data strobe block, configured to select a signal with a duty cycle greater than the target duty cycle from the initial clock signal and the inverted signal of the initial clock signal as the input clock signal and output it according to a preset duty cycle selection control signal.

Optionally, the second data strobe block comprises a multiplexer.

Optionally, the target duty cycle is 50%.

Correspondingly, the disclosure also provides a clock duty cycle calibration method, comprising:
Performing delay matching processing on the calibration clock signal, to acquire a delay-matched clock signal, the first edge of the delay-matched clock signal is aligned with the first edge of the calibration clock signal, and the delay-matched clock signal has the same duty cycle as the calibration clock signal;
Performing a frequency multiplication processing on the calibration clock signal, to acquire the corresponding frequency-multiplied clock signal; The first edge of the frequency-multiplied clock signal is aligned with the first edge of the calibration clock signal, and the frequency of the frequency-multiplied clock signal is a multiple of the frequency of the calibration clock signal;
Performing the first phase-locked processing on the frequency-multiplied clock signal ,to acquire the first oscillating clock signal; performing the first frequency division processing on the first oscillating clock signal ,to acquire the first feedback clock signal; Wherein, when the phase-locked loop cell is in the first locked state, the first edge of the first feedback clock signal is aligned with the first edge of the frequency-multiplied clock signal, and the first feedback clock signal has the same frequency as the frequency-multiplied clock signal;
When the phase-locked loop cell is in the first locked state, using the first feedback clock signal to perform a first sampling processing on the delay-matched clock signal, to acquire the first sampled signal; According to the first sampled signal, generate the first calibration control signal.

Performing a first duty cycle calibration processing on the input clock signal according to the first calibration control signal, that maintain the duty cycle of the calibration clock signal at the target duty cycle.

Correspondingly, the disclosure also provides a clock multiplier circuit comprising the clock duty cycle calibration circuit, comprising:
a duty cycle calibration cell, configured to perform the first duty cycle calibration processing on the input clock signal according to the first calibration control signal, to maintain the duty cycle of the calibration control signal at the target duty cycle;
a delay matching cell, configured to perform delay matching processing on the calibration clock signal, to acquire a delay-matched clock signal, the first edge of the delay-matched clock signal is aligned with the first edge of the calibration clock signal, and the delay-matched clock signal has the same duty cycle as the calibration control signal;
a signal frequency multiplier cell, configured to perform frequency multiplication processing on the calibration clock signal, to acquire the corresponding frequency-multiplied clock signal, the first edge of the frequency-multiplied clock signal is aligned with the first edge of the calibration clock signal, and the frequency of the frequency-multiplied clock signal is a multiple of the frequency of the calibration clock signal;
a phase-locked loop cell, configured to perform the first phase-locked processing on the frequency-multiplied clock signal ,to acquire the first oscillating clock signal; and perform the first frequency division processing on the first oscillating clock signal ,to acquire the first feedback clock signal; Wherein, when the phase-locked loop cell is in the first locked state, the first edge of the first feedback clock signal is aligned with the first edge of the frequency-multiplied clock signal, and the first feedback clock signal has the same frequency as the frequency-multiplied clock signal;
a calibration control cell, configured to, when the phase-locked loop cell is in the locked state, perform a first sampling processing on delay-matched clock signal using the first feedback clock signal, to acquire the first sampled signal; According to the first sampled signal, generate the first calibration control signal.

Compared with the prior art, the technical solution of the disclosure embodiment has the following advantages:
The embodiment of the disclosure provides a clock duty cycle calibration circuit, comprising: a duty cycle calibration cell, configured to perform the first duty cycle calibration processing on the input clock signal according to the first calibration control signal, to maintain the duty cycle of the calibration control signal at the target duty cycle; a delay matching cell, configured to perform delay matching processing on the calibration clock signal, to acquire a delay-matched clock signal, the first edge of the delay-matched clock signal is aligned with the first edge of the calibration clock signal, and the delay-matched clock signal has the same duty cycle as the calibration control signal; a signal frequency multiplier cell, configured to perform frequency multiplication processing on the calibration clock signal ,to acquire the corresponding frequency-multiplied clock signal, the first edge of the frequency-multiplied clock signal is aligned with the first edge of the calibration clock signal, and the frequency of the frequency-multiplied clock signal is a multiple of the frequency of the calibration clock signal; a phase-locked loop cell, configured to perform the first phase-locked processing on the frequency-multiplied clock signal ,to acquire the first oscillating clock signal; and perform the first frequency division processing on the first oscillating clock signal ,to acquire the first feedback clock signal; Wherein, when the phase-locked loop cell is in the first locked state, the first edge of the first feedback clock signal is aligned with the first edge of the frequency-multiplied clock signal, and the first feedback clock signal has the same frequency as the frequency-multiplied clock signal calibration control cell, configured to, when the phase-locked loop cell is in the locked state, perform a first sampling processing on delay-matched clock signal using the first feedback clock signal ,to acquire the first sampled signal ; According to the first sampled signal, generate the first calibration control signal.

In the clock duty cycle calibration circuit of the embodiment of the disclosure, generating a delay-matched clock signal that is aligned with the first edge of the calibration clock signal and has the same duty cycle as the calibration clock signal using the delay matching cell, and using the signal frequency multiplier cell to perform a frequency multiplication processing on the calibration clock signal to acquire a frequency-multiplied clock signal that is aligned with the first edge of the calibration clock signal and the frequency is a multiple of the frequency of the calibration clock signal, and using the phase-locked loop cell in the first lock state to generate a first reference clock signal that is aligned with the first edge of the frequency-multiplied clock signal and the frequency is the same as the frequency of the frequency-multiplied clock signal, thereby using the calibration control cell to perform a first sampling process on the delay-matched clock signal using the first feedback clock signal when the phase-locked loop cell is in the first locked state, can acquire a first sampled signal that used to instruct the relationship between the actual duty cycle of the calibration clock signal and the target duty cycle, the calibration control cell generates the first calibration control signal according to the first sampled signal, thereby enable the duty cycle calibration cell to maintain the duty cycle of the calibration control signal at the target duty cycle according to the first calibration control signal, that can overcome duty cycle offset caused by operating temperature, which helps improve the accuracy of the generated calibration clock signal.

### BRIEF DESCRIPTION OF THE DRAWINGS

FIG. 1 is a circuit structure diagram in an embodiment of the clock duty cycle calibration circuit provided by the technical solution of the disclosure.
FIG. 2 is a waveform diagram of relevant signals in an embodiment of the clock duty cycle calibration circuit provided by the technical solution of the disclosure.
FIG. 3 is a schematic diagram of duty cycle variation of the calibration clock signal in the clock duty cycle calibration circuit provided by the technical solution of the disclosure.
FIG. 4 is a circuit structure diagram in another embodiment of the clock duty cycle calibration circuit provided by the technical solution of the disclosure.
FIG. 5 is a schematic flowchart in an embodiment of a clock duty cycle calibration method provided by the technical solution of the disclosure.

### DETAILED DESCRIPTION

As can be seen from the background technology, the accuracy of the calibration clock signal generated by the clock duty cycle calibration circuit still needs to be improved, which affects the quality of wireless communication.

To solve the above technical problems, the embodiment of the disclosure provides a clock duty cycle calibration circuit, comprising: a duty cycle calibration cell, configured to perform the first duty cycle calibration processing on the input clock signal according to the first calibration control signal, to maintain the duty cycle of the calibration control signal at the target duty cycle; a delay matching cell, configured to perform delay matching processing on the calibration clock signal, to acquire a delay-matched clock signal, the first edge of the delay-matched clock signal is aligned with the first edge of the calibration clock signal, and the delay-matched clock signal has the same duty cycle as the calibration control signal; a signal frequency multiplier cell, configured to perform frequency multiplication processing on the calibration clock signal ,to acquire the corresponding frequency-multiplied clock signal, the first edge of the frequency-multiplied clock signal is aligned with the first edge of the calibration clock signal, and the frequency of the frequency-multiplied clock signal is a multiple of the frequency of the calibration clock signal; a phase-locked loop cell, configured to perform the first phase-locked processing on the frequency-multiplied clock signal ,to acquire the first oscillating clock signal; and perform the first frequency division processing on the first oscillating clock signal ,to acquire the first feedback clock signal; Wherein, when the phase-locked loop cell is in the first locked state, the first edge of the first feedback clock signal is aligned with the first edge of the frequency-multiplied clock signal, and the first feedback clock signal has the same frequency as the frequency-multiplied clock signal calibration control cell, configured to, when the phase-locked loop cell is in the locked state, perform a first sampling processing on delay-matched clock signal using the first feedback clock signal ,to acquire the first sampled signal ; According to the first sampled signal, generate the first calibration control signal.

In the clock duty cycle calibration circuit of the embodiment of the disclosure, generating a delay-matched clock signal that is aligned with the first edge of the calibration clock signal and has the same duty cycle as the calibration clock signal using the delay matching cell, and using the signal frequency multiplier cell to perform a frequency multiplication processing on the calibration clock signal to acquire a frequency-multiplied clock signal that is aligned with the first edge of the calibration clock signal and the frequency is a multiple of the frequency of the calibration clock signal, and using the phase-locked loop cell in the first lock state to generate a first reference clock signal that is aligned with the first edge of the frequency-multiplied clock signal and the frequency is the same as the frequency of the frequency-multiplied clock signal, thereby using the calibration control cell to perform a first sampling process on the delay-matched clock signal using the first feedback clock signal when the phase-locked loop cell is in the first locked state, can acquire a first sampled signal that used to instruct the relationship between the actual duty cycle of the calibration clock signal and the target duty cycle, the calibration control cell generates the first calibration control signal according to the first sampled signal, thereby enable the duty cycle calibration cell to maintain the duty cycle of the calibration control signal at the target duty cycle according to the first calibration control signal, that can overcome duty cycle offset caused by operating temperature, which helps improve the accuracy of the generated calibration clock signal.

To make the above objectives, features, and advantages of the disclosure more obvious and understandable, specific embodiments of the disclosure are described in detail below with reference to the accompanying drawings.

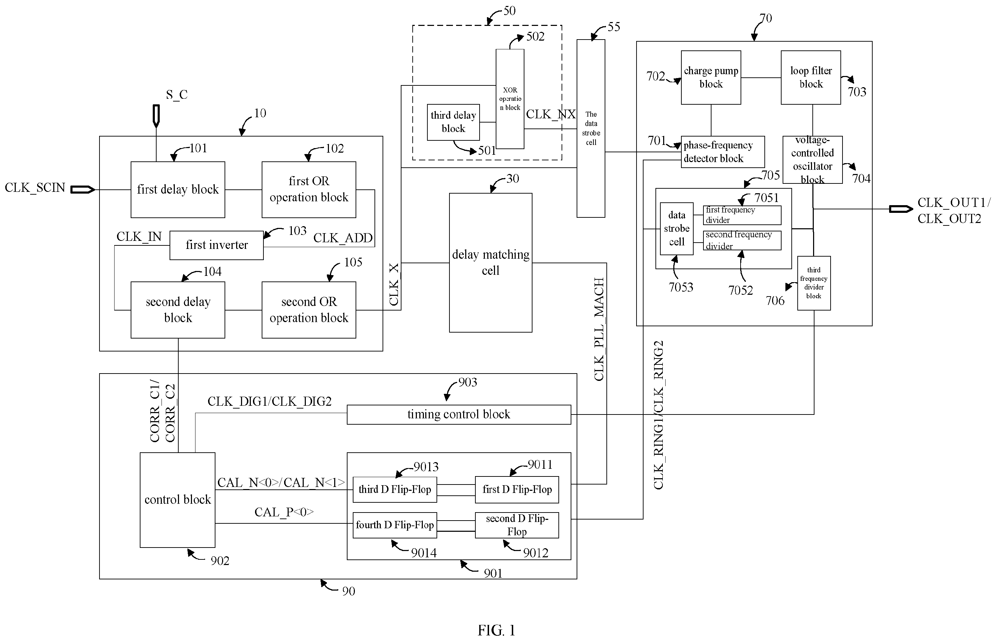

FIG. 1 is a circuit structure diagram in an embodiment of the clock duty cycle calibration circuit provided by the technical solution of the disclosure.

With reference to FIG. 1, a clock duty cycle calibration circuit comprising: a duty cycle calibration cell 10, a delay matching cell 30, a signal frequency multiplier cell 50,a phase-locked loop cell 70 and a calibration control cell 90.Wherein, the duty cycle calibration cell 10 is respectively coupled to the delay matching cell 30, the signal frequency multiplier cell 50,the phase-locked loop cell 70 and the calibration control cell 90, the signal frequency multiplier cell 50 is coupled to the phase-locked loop cell 70,the calibration control cell 90 is also coupled to the delay matching cell 30 and the phase-locked loop cell 70.

In this embodiment, the duty cycle calibration cell 10 is provided with control port, input port, output port. Wherein, the calibration control port of the duty cycle calibration cell 10 is coupled to the calibration control cell 90, the input port of the duty cycle calibration cell 10 configured to receive the input clock signal CLK_SCIN, the output port of the duty cycle calibration cell 10 are respectively coupled to the delay matching cell 30, the signal frequency multiplier cell 50,the phase-locked loop cell 70. The duty cycle calibration cell 10 configured to perform the first duty cycle calibration processing on the input clock signal CLK_SCIN according to the first calibration control signal CORR_C1, to maintain the duty cycle of the calibration control signal CLK_X at the target duty cycle.

Specifically, the duty cycle calibration cell 10 comprising: a first delay block 101, a first OR operation block 102, a first inverter 103, a second delay block 104 and a second OR operation block 105.Wherein:
The first delay block 101 is provided with an input port, a first output port and a second output port. Wherein, the input port of the first delay block 101 is used as the input port of the duty cycle calibration cell 10 or coupled to the input port of the duty cycle calibration cell 10, the first output port of the first delay block 101 is coupled to the first input port of the first OR operation block 102, the second output port of the first delay block 101 is coupled to the second input port of the first OR operation block 102. The first delay block 101 configured to perform a first delay processing on the input clock signal CLK_SCIN, to acquire the first delayed clock signal, the duty cycle of the first delay clock signal is greater than the duty cycle of the input clock signal CLK_SCIN.

The first OR operation block 102 is provided with a first input port, a second input port, and an output port. Wherein, the first input port of the first OR operation block 102 is coupled to the first output port of the first delay block 101, the second input port of first OR operation block 102 is coupled to the second output port of the first delay block 101, the output port of the first OR operation block 102 is coupled to the input port of the first inverter 103. The first OR operation block 102 configured to perform OR operation processing on the input clock signal CLK_SCIN and the first delay signal, to acquire the summed clock signal CLK_ADD.

The first inverter 103 is provided with an input port and an output port. Wherein, the input port of the first inverter 103 is coupled to the output port of the first OR operation block 102, the output port of the first inverter 103 is coupled to the first input port and the second input port of the second delay block 104.The first inverter 103 configured to perform inversion processing on the summed clock signal, to acquire the inverted signal CLK_IN of the summed clock signal.

The second delay block 104 is provided with a control port, a first input port, a second input port, a first output port, and a second output port. Wherein, the control port of the second delay block 104 is used as the calibration control port of the duty cycle calibration cell 10 or coupled to the calibration control port of the duty cycle calibration cell 10,the first input port and second input port of the second delay block 104 are respectively coupled to the output ports of the first inverter 103, the first output port of the second delay block 104 is coupled to the first input port of the second OR operation block 105, the second output port of the second delay block 104 is coupled to the second input port of the second OR operation block 105. The second delay block 104 configured to perform a second delay processing on the inverted signal CLK_IN of the summed clock signal according to the first calibration control signal CORR_C1, to acquire a second delay clock signal.

The second OR operation block 105 is provided with a first input port, a second input port and an output port. Wherein, the first input port and second input port of the second OR operation block 105 are respectively coupled to the output port of the first inverter 103, the output port of the second OR operation block 105 is used as the output port of the duty cycle calibration cell 10 or coupled to the output port of the duty cycle calibration cell 10. The second OR operation block 105 configured to perform OR operation processing on the inverted signal CLK_IN of the summed clock signal and the second delay clock signal, to acquire the calibration clock signal CLK_X.

Those skilled in the art will understand that the duty cycle calibration cell may also be implemented through other structures with the same functions, which will not be limited herein.

In this embodiment, the delay matching cell 30 is provided with an input port and an output port. Wherein, the input port of the delay matching cell 30 is coupled to the output port of the duty cycle calibration cell 10, the output port of the delay matching cell 30 is coupled to the calibration control cell 90. The delay matching cell 30 configured to perform delay matching processing on the calibration clock signal CLK_X, to acquire the delay-matched clock signal CLK_PLL_MATCH. Wherein, the first edge of the delay-matched clock signal CLK_PLL_MATCH is aligned with the first edge of the calibration clock signal CLK_X, and the delay-matched clock signal CLK_PLL_MATCH has the same duty cycle as the calibration clock signal CLK_X.

Specifically, the delay matching cell 30 is a time delay cell. Those skilled in the art will understand that the delay matching cell may also be implemented through other structures with the same functions, which will not be limited herein.

In this embodiment, the signal frequency multiplier cell 50 is provided with a first input port, a second input port, and output port. Wherein, the first input port and the second input port of the signal frequency multiplier cell 50 are respectively coupled to output port of the duty cycle calibration cell 10, the output port of the signal frequency multiplier cell 50 is coupled to the phase-locked loop cell 70.The signal frequency multiplier cell 50, configured to perform frequency multiplication processing on the calibration clock signal CLK_X ,to acquire the corresponding frequency-multiplied clock signal, the first edge of the frequency-multiplied clock signal CLK_NX is aligned with the first edge of the calibration clock signal CLK_X, and the frequency of the frequency-multiplied clock signal CLK_NX is a multiple of the frequency of the calibration clock signal CLK_X;

In this embodiment, the frequency of the frequency-multiplied clock signal CLK_NX is twice that of the frequency of the calibration clock signal CLK_X.

Correspondingly, the signal frequency multiplier cell 50 comprises: a third delay block 501 and a XOR operation block 502, wherein:
The third delay block 501 is provided with an input port and an output port. Wherein, the input port of the third delay block 501 is used as the first input port of the signal frequency multiplier cell 50 or coupled to the first input port of the signal frequency multiplier cell 50, the output port of the third delay block 501 is coupled to the XOR operation block 502.The third delay block 501 configured to perform a third delay processing on the calibration clock signal CLK_X ,to acquire a third delay clock signal.

The XOR operation block 502 is provided with a first input port, a second input port, and a output port. Wherein, the first input port of the XOR operation block 502 is coupled to the output port of the third delay block 501,the second input port of the XOR operation block 502 is used as the second input port of the signal frequency multiplier cell 50 or coupled to the second input port of the signal frequency multiplier cell 50, the output port of the XOR operation block 502 is used as the output port of the signal frequency multiplier cell 50 or coupled to the output port of the signal frequency multiplier cell 50. The XOR operation block 502, configured to perform XOR operation processing on the calibration clock signal CLK_X and the third delay clock signal, to acquire the frequency-multiplied clock signal CLK_NX.

In other embodiments, the signal frequency multiplier cell can also be implemented through other structures with the same functions, which will not be limited herein.

In this embodiment, the phase-locked loop cell 70 is provided with a first input port, a second input port, a first output port, a second output port. Wherein, the first input port of the phase-locked loop cell 70 is coupled to the duty cycle calibration cell 10, the first input port of the phase-locked loop cell 70 is coupled to the second output port of the phase-locked loop cell 70, the first output port of the phase-locked loop cell 70 configured to output the first oscillation clock signal CLK _OUT1. The phase-locked loop cell 70 configured to perform the first phase-locked processing on the calibration clock signal CLK_X ,to acquire the first oscillation clock signal CLK_OUT1; and perform first frequency division processing on the first oscillation clock signal CLK_OUT1,to acquire the first feedback clock signal CLK_RING1; Wherein, when the phase-locked loop cell is in the first locked state, the first edge of the first feedback clock signal CLK_RING1 is aligned with the first edge of the frequency-multiplied clock signal CLK_NX and has a target duty cycle, and the first feedback clock signal CLK_RING1 has the same frequency as the frequency-multiplied clock signal CLK_NX.

Specifically, the phase-locked loop cell 70 comprises: a phase-frequency detector block 701, a charge pump block 702, a loop filter block 703, a voltage-controlled oscillator block 704 and a first frequency divider block 705.Wherein:
The phase-frequency detector block 701 is provided with a first input port, a second input port, a first output port, and a second output port. Wherein, the first input port of the phase-frequency detector block 701 is used as the first input port of the phase-locked loop cell 70 or coupled to the first input port of the phase-locked loop cell 70, the second input port of the phase-frequency detector block 701 is used as the second input port of the phase-locked loop cell 70 or coupled to the second input port of the phase-locked loop cell 70,the first output port and second output port of the phase-frequency detector block 701 are respectively coupled to the charge pump block 702. The phase-frequency detector block 701 configured to acquire the first phase difference signal according to the phase difference between the frequency-multiplied clock signal CLK_NX and the first feedback clock signal CLK_RING1.

The charge pump block 702 is provided with a first input port, a second input port and an output port. Wherein, the first input port of the charge pump block 702 is coupled to the first output port of the phase-frequency detector block 701, the second input port of the charge pump block 702 is coupled to the second output port of the phase-frequency detector block 701, the output port of the charge pump block 702 is coupled to the loop filter block 703. The charge pump block 702 configured to convert the phase difference signal into a first current signal.

The loop filter block 703 is provided with an input port and an output port. Wherein, the input port of the loop filter block 703 is coupled to the output port of the charge pump block 702, the output port of the loop filter block 703 is coupled to the voltage-controlled oscillator block 704. The loop filter block 703 configured to perform low-pass filter processing on the first current signal.

The voltage-controlled oscillator block 704 is provided with an input port and an output port. Wherein, the input port of the voltage-controlled oscillator block 704 is coupled to the output port of the loop filter block 703, the output port of the voltage-controlled oscillator block 704 is used as the first output port of the phase-locked loop cell 70 or coupled to the first output port of the phase-locked loop cell 70. The voltage-controlled oscillator block 704 configured to acquire a first oscillation clock signal CLK_OUT1 according to the first current signal. Wherein, the oscillation frequency of the first oscillation clock signal CLK_OUT1 has a one-to-one correspondence relationship with the first current signal.

The first frequency divider block 705 is provided with an input port and an output port. Wherein, the input port of the first frequency divider block 705 is coupled to the output port of the voltage-controlled oscillator block 704, the output port of the first frequency divider block 705 is used as the second output port of the phase-locked loop cell 70 or coupled to the second output port of the phase-locked loop cell 70. The first frequency divider block 705 configured to perform the first frequency division processing on the first oscillation clock signal CLK_OUT1, to acquire the first feedback clock signal CLK_RING1.

As an example, the first frequency divider block 705 comprises a first frequency divider 7051 and a second frequency divider 7052.Wherein:
The first frequency divider 7051 is provided with an input port and an output port. Wherein, the input port of the first frequency divider 7051 is used as the input port of the first frequency divider block 705 or coupled to the input port of the first frequency divider block 705, the output port of the first frequency divider 7051 is coupled to the input port of the second frequency divider 7052. The first frequency divider 7051 configured to perform the first sub frequency division processing on the first oscillation clock signal CLK_OUT1, to acquire the first frequency-divided signal.

The second frequency divider 7052 is provided with an input port and an output port. Wherein, the input port of the second frequency divider 7052 is coupled to the output port of the first frequency divider 7051,the output port of the second frequency divider 7052 is used as the output port of the first frequency divider block 705 or coupled to the output port of the first frequency divider block 705.The second frequency divider 7052 configured to perform the second sub frequency division processing on the first frequency-divided signal ,to acquire the first feedback clock signal CLK_RING1.

In specific embodiments, the first frequency divider 7051 is a step frequency divider with a step value of 1/2ⁿ , wherein n is an integer greater than or equal to 0.For example, when n=0, the first frequency divider 7051 is a step frequency divider with a step value of 1; when n=1, the first frequency divider 7051 is a step frequency divider with a step value of 0.5.when n=2, the first frequency divider 7051 is a step frequency divider with a step value of 0.25.

In this embodiment, the second frequency divider 7052 is a frequency divider-by-2.

It is understandable that when the clock duty cycle calibration circuit in the embodiment of the disclosure is applied to a clock multiplier circuit, by setting the step value 1/2 " of the step frequency divider, can enable of the first oscillation clock signal output by the clock duty cycle calibration circuit is an odd multiple or an even multiple of the reference clock signal input to the phase-locked loop cell 70.

For example, when n=0, the first frequency divider 7051 is a step frequency divider with a step value of 1,the first oscillation clock signal CLK_OUT1 output by the phase-locked loop cell 70 is an even multiple of the reference clock signal input to the phase-locked loop cell 70; For example, when n=1, the first frequency divider 7051 is a step frequency divider with a step value of 0.5,the first oscillation clock signal CLK_OUT1 output by the phase-locked loop cell 70 is an odd multiple or even multiple of the reference clock signal input to the phase-locked loop cell 70.

The structure of the phase-locked loop cell described above is merely an example. It is understood that the phase-locked loop cell can also be implemented through other structures with the same functions, and those skilled in the art can set it according to actual needs, which will not be limited herein.

In this embodiment, the calibration control cell 90 is provided with a first input port, a second input port and a calibration control signal output port. Wherein, the first input port of the calibration control cell 90 is coupled to the output port of the delay matching cell 30,the second input port of the calibration control cell 90 is coupled to the second output port of the phase-locked loop cell 70, the calibration control signal output port of the calibration control cell 90 is coupled to the calibration control port of the duty cycle calibration cell 10.The calibration control cell 90 configured to, when the phase-locked loop cell 70 is in the first locked state, perform a first sampling processing on the delay-matched clock signal CLK_PLL_MATCH using the first feedback clock signal CLK_RING1,to acquire the first sampled signal ; According to the first sampled signal, generate the first calibration control signal CORR_C1.

In this embodiment, the first calibration control signal comprises multiple fine adjustment step control signals one-to-one corresponding to multiple fine adjustment steps. Correspondingly, the calibration control cell 90,configured to, when the phase-locked loop cell is in the first locked state, generate coarse adjustment step control signal corresponding to the corresponding fine adjustment step according to the first sampled signal and output to the duty cycle calibration cell, until the duty cycle of the calibration clock signal CLK_X reaches the target duty cycle.

Specifically, the calibration control cell 90 comprises a sampling block 901 and a control block 902.Wherein:
The sampling block 901 is provided with a first input port, a second input port and an output port. Wherein, the first input port of the sampling block 901 is used as the first input port of the calibration control cell 90 or coupled to the first input port of the calibration control cell 90, the second input port of the sampling block 901 is used as the second input port of the calibration control cell 90 or coupled to the second input port of the calibration control cell 90,the output port of the sampling block 901 is coupled to the control block 902. The sampling block 901, configured to, when the phase-locked loop cell 70 is in the first locked state, perform the first sampling processing on the delay-matched clock signal CLK_PLL_MATCH using the first feedback clock signal CLK_RING1, to acquire the first sampled signal, the first sampled signal is used to instruct the relationship between the duty cycle of the calibration clock signal CLK_X and the target duty cycle.

In this embodiment, the sampling block 901 comprises a first D Flip-Flop 9011, a second D Flip-Flop 9012, a third D Flip-Flop 9013, and a fourth D Flip-Flop 9014. Wherein:
The first D Flip-Flop 9011 is provided with a data input port, a clock input port and a data output port. Wherein: the data input port of the first D Flip-Flop 9011 is used as the first input port of the sampling block 901 or coupled to the first input port of the sampling block 901,the clock input port of the first D Flip-Flop 9011 is used as the second input port of the sampling block 901 or coupled to the second input port of the sampling block 901,the data output port of the first D Flip-Flop 9011 is used as the output port of the sampling block 901 or coupled to the output port of the sampling block 901.The first D Flip-Flop 9011, configured to, when the second edge of the first feedback clock signal CLK_RING1 arrives, perform a first sub sampling processing on the delay-matched clock signal CLK_PLL_MATCH ,to acquire the first sub sampled signal CAL_N<1>.

The second D Flip-Flop 9012 is provided with a data input port, a clock input port and a data output port. Wherein: the data input port of the second D Flip-Flop 9012 is used as the first input port of the sampling block 901 or coupled to the first input port of the sampling block 901,the clock input port of the second D Flip-Flop 9012 is used as the second input port of the sampling block 901 or coupled to the second input port of the sampling block 901,the data output port of the second D Flip-Flop 9012 is coupled to the data input port of the fourth D Flip-Flop 9014.The second D Flip-Flop 9012 configured to, after acquiring the first sub sampled signal and when the first edge of the first feedback clock signal CLK_RING1 arrives ,perform a second sub sampling processing on the delay-matched clock signal CLK_PLL_MATCH, to acquire the second sub sampled signal CAL_P<0>.

The third D Flip-Flop 9013 is provided with a data input port, a clock input port and a data output port. Wherein: the data input port of the third D Flip-Flop 9013 is coupled to the data output port of the first D Flip-Flop 9011,the clock input port of the third D Flip-Flop 9013 is used as the second input port of the sampling block 901 or coupled to the second input port of the sampling block 901,the data output port of the third D Flip-Flop 9013 is used as the first output port of the sampling block 901 or coupled to the first output port of the sampling block 901.The third D Flip-Flop 9013 configured to, after acquiring the second sub sampled signal CAL_P<0> and when the second edge of the first feedback clock signal CLK_RING1 arrives, transmit the first sub sampled signal CAL_N<1> to the control block 902 ;

The fourth D Flip-Flop 9014 is provided with a data input port, a clock input port and a data output port. Wherein: the data input port of the fourth D Flip-Flop 9014 is used as the first input port of the sampling block 901 or coupled to the first input port of the sampling block 901,the clock input port of the fourth D Flip-Flop 9014 is used as the second input port of the sampling block 901 or coupled to the second input port of the sampling block 901,the data output port of the fourth D Flip-Flop 9014 is used as the second output port of the sampling block 901 or coupled to the second output port of the sampling block 901.The fourth D Flip-Flop 9014 configured to, after acquiring the second sub sampled signal CAL_P<0> and when the second edge of the first feedback clock signal CLK_RING1 arrives, transmit the second sub sampled signal CAL_P<0> to the control block 902.

In this embodiment, the first edge is the rising edge, and the second edge is the falling edge. Correspondingly, the first D Flip-Flop 9011, the third D Flip-Flop 9013, and the fourth D Flip-Flop 9014 are the falling edge D Flip-Flop, the second D Flip-Flop 9012 is the rising edge D Flip-Flop.

The control block 902 is provided with a first input port, a second input port, and a calibration signal output port. Wherein, the first input port of control block 902 is coupled to the first output port of the sampling block 901, the second input port of control block 902 is coupled to the second output port of the sampling block 901, the calibration signal output port of the control block 902 is used as the calibration signal output port of the calibration control cell 90 or coupled to the calibration signal output port of the calibration control cell 90. The control block 902 configured to generate the first calibration control signal CORR_C1 according to the first sampled signal.

In this embodiment, the first sampled signal comprises the first sub sampled signal CAL_N<1> and the second sub sampled signal CAL_P<0>. Correspondingly, The control block 902 configured to generate the first calibration control signal CORR_C1 according to the first calibration control signal CORR_C1 according to the first sampled signal.

Specifically, the control block 902 configured to acquire the sampled values of the first sub sampled signal CAL_N<1> and the sampled values of the second sub sampled signal CAL_P<0> according to a preset first control period; If the sampled values of the first sub sampled signal CAL_N<1> are all the first sampled value and the sampled values of the second sub sampled signal CAL_P<0> are all the second sampled value within the first control period, then generate a first calibration control signal to instruct the duty cycle calibration cell 10 to increase the duty cycle of the calibration clock signal; If the sampled values of the first sub sampled signal CAL_N<1> are all the first sampled value and the sampled values of the second sub sampled signal CAL_P<0> are all the third sampled value within the first control period, then generate a first calibration control signal to instruct the duty cycle calibration cell 10 to reduce the duty cycle of the calibration clock signal; For example, the first sampled value and the third sampled value are both 1,the second sampled value is 0.

In this embodiment, the control block 902 is a digital frequency multiplier with a low-pass filter.

Those skilled in the art will understand that the calibration control cell may also be implemented through other structures with the same functions, which will not be limited herein.

In this embodiment, the target duty cycle is 50%. It should be noted that the target duty cycle can also be other values, which will not be limited herein.

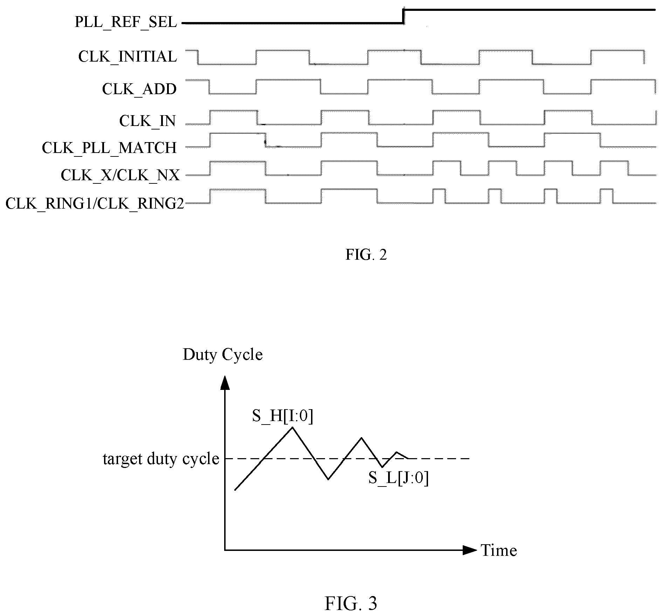

FIG. 2 is a waveform diagram of relevant signals in an embodiment of the clock duty cycle calibration circuit provided by the technical solution of the disclosure.

The following describes the working principle of the duty cycle calibration circuit in this embodiment reference to the FIG. 1 to FIG. 2.

Taking a target duty cycle of 50% as an example, firstly, the duty cycle calibration circuit in this embodiment uses the delay matching cell 30, phase-locked loop cell 70, and calibration control cell 90 in the first calibration stage to generate the second calibration control signal CORR_C2 according to the relationship between the duty cycle of the calibration clock signal CLK_X output by the duty cycle calibration cell 10 and the target duty cycle, that enable the duty cycle calibration cell 10 to perform a second duty cycle calibration processing on the input clock signal CLK_SCIN according to the second calibration control signal CORR_C2 until the duty cycle of the output calibration clock signal CLK_X reaches the target duty cycle, thereby overcoming the offset in the duty cycle of the calibration clock signal CLK_X caused by process, voltage, and temperature. Subsequently, the duty cycle calibration circuit in this embodiment uses the delay matching cell 30, the signal frequency multiplier cell 50, the phase-locked loop cell 70, and the calibration control cell 90 in the second calibration stage to generate the corresponding first calibration control signal CORR_C1 according to the relationship between the duty cycle of the calibrated clock signal CLK_X output by the duty cycle calibration cell 10 and the target duty cycle, thereby overcoming the offset in the duty cycle of the calibration clock signal CLK_X caused by the operating temperature and maintain the duty cycle of the calibration clock signal CLK_X at the target duty cycle.

In this embodiment, using the reference selection control signal PLL_REF_SEL generated by the calibration control cell 90 to control the transition between the first calibration stage and the second calibration stage.

Specifically, during the process of performing a second duty cycle calibration processing on the input clock signal CLK_SCIN according to the second calibration control signal CORR_C2 until the duty cycle of the calibration clock signal CLK_X reaches the target duty cycle, the calibration control cell 90 generates a reference selection control signal PLL_REF_SEL with a first logic level; When performing a second duty cycle calibration processing on the input clock signal CLK_SCIN according to the second calibration control signal CORR_C2 until the duty cycle of the calibration clock signal CLK_X reaches the target duty cycle, the calibration control cell 90 converts the logic level of the reference selection control signal PLL_REF_SEL from the first logic level to the second logic level, thereby entering the second calibration stage. For example, the first logic level is a logic low level, and the second logic level is a logic high level.

Referring to FIG. 1 to FIG. 2, the calibration control cell 90 generates a reference selection control signal PLL_REF_SEL with a first logic level, correspondingly, the clock duty cycle calibration circuit enters the first calibration stage:
Specifically, in the duty cycle calibration cell 10,when receiving the input clock signal CLK_SCIN, the first delay block 101 performs the first delay processing on the input clock signal CLK_SCIN ,to acquire the first delay clock signal, and the first OR operation block 102 performs an OR operation on the input clock signal CLK_SCIN and the first delay clock signal ,to acquire the summed clock signal CLK_ADD, thereby further increasing the duty cycle of the summed clock signal CLK_ADD, then the first inverter 103 performs an inversion processing on the summed clock signal ,to acquire the inverted signal of the summed clock signal CLK_IN.

Next, in the duty cycle calibration cell 10, the second delay block 104 receives the inverted signal CLK_IN of the summed clock signal, and performs a second delay processing on the inverted signal CLK_IN of the summed clock signal according to the second calibration control signal CORR_C2,to acquire the second delay clock signal, then, the second OR operation block 105 performs an OR operation processing on the inverted signal CLK_IN of the summed clock signal and the second delay clock signal, to acquire the calibration clock signal CLK_X.

Subsequently, using the delay matching cell 30, phase-locked loop cell 70 and calibration control cell 90 , can acquire the relationship between the actual duty cycle of the calibration clock signal CLK_X output by the duty cycle calibration cell 10 and the target duty cycle in real time, and generate the corresponding second calibration control signal CORR_C2, that perform real-time dynamic calibration of the actual duty cycle of the calibration clock signal CLK_X.

Specifically, the delay matching cell 30 performs delay matching processing on the calibration clock signal CLK_X, to acquire the delay-matched clock signal CLK_PLL_MATCH. Wherein, there is a corresponding delay between the phase of the delay-matched clock signal CLK_PLL_MATCH and the phase of the delay-matched clock signal CLK_PLL_MATCH, that enable the first edge of the delay-matched clock signal CLK_PLL_MATCH aligns with the first edge of the calibration clock signal CLK_X, and the delay-matched clock signal CLK_PLL_MATCH and the calibration clock signal CLK_X have the same duty cycle.

At the same time, the logic level of the reference selection control signal PLL_REF_SEL output by the calibration control cell 90 is the first logic level, and the data strobe cell 55 selects and outputs the calibration clock signal CLK_X output by the duty cycle calibration cell10 to the phase-locked loop cell 70.

In the phase-locked loop cell 70, the phase-frequency detector block 701 output the second phase difference signal according to the phase difference between the calibration clock signal CLK_X and the second feedback clock signal CLK_RING2, and the charge pump block 702 converts the phase difference signal into a current signal, then using the loop filter block 703 to perform low-pass filter processing on the second current signal ,the second current signal after low-pass filtering enters the voltage-controlled oscillator block 704, and the voltage-controlled oscillator block 704 acquires the second oscillation clock signal CLK_OUT2 according to the second current signal, the first frequency divider block 705 performs the second frequency division processing on the second oscillation clock signal CLK_OUT2 output by the voltage-controlled oscillator block 704,to acquire the corresponding second feedback clock signal CLK_RING2.In this way, the loop repeats until the phase-locked loop cell 70 enters the second locked state.

Wherein, when the phase-locked loop cell 70 is in the second locked state, the first edge of the second feedback clock signal CLK_RING2 is aligned with the first edge of the calibration clock signal CLK_X. Meanwhile, the second feedback clock signal CLK_RING2 is acquired by the second frequency divider 7052 in the first divider block 705 performing the second frequency division processing on the second oscillation clock signal CLK_OUT2, enable the duty cycle of the second feedback clock signal CLK_RING2 is the target duty cycle when the phase-locked loop cell 70 is in the second locked state.

At the same time, the first edge of the delay-matched clock signal CLK_PLL_MATCH output by the delay matching cell 30 is aligned with the first edge of the calibration clock signal CLK_X, and the delay-matched clock signal CLK_PLL_MATCH and the calibration clock signal CLK_X have the same duty cycle.

Correspondingly, the calibration control cell 90 utilizes the second feedback clock signal CLK_RING2 output by the phase-locked loop cell 70 when in the second locked state, as well as the delay-matched clock signal CLK_PLL_MATCH output by the delay matching cell 30 respectively in relation to the calibration clock signal CLK_X, through the second edge of the second feedback clock signal CLK_RING2 output by the phase-locked loop cell 70 in the second locked state to perform the second sampling on the delay-matched clock signal CLK_PLL_MATCH output by the delay matching cell 30, can acquire the relationship between the duty cycle of the delay-matched clock signal CLK_PLL_MATCH and the target duty cycle that the second feedback clock signal CLK_RING2 owned.

At the same time, the duty cycle of the delay-matched clock signal CLK_PLL_MATCH is the same as the duty cycle of the calibration clock signal CLK_X, so the relationship between the duty cycle of the delay-matched clock signal CLK_PLL_MATCH and the target duty cycle of the second feedback clock signal CLK_RING2, that is to say the relationship between the duty cycle of the calibration clock signal CLK_X and the target duty cycle.

Therefore, using the second edge of the second feedback clock signal CLK_RING2 output by the phase-locked loop cell 70 in the locked state to perform sampling on the delay-matched clock signal CLK_PLL_MATCH output by the delay matching cell 30, that can acquire the relationship between the duty cycle of the calibration clock signal CLK_X and the target duty cycle, thereby according to the relationship between the duty cycle of the calibration clock signal CLK_X and the target duty cycle generate the corresponding calibration control signal to the duty cycle calibration cell 10, that can calibrate the calibration clock signal CLK_X to the target duty cycle.

Specifically, in the calibration control cell 90,the sampling block 901 uses the second feedback clock signal CLK_RING2 to perform a second sampling on the delay-matched clock signal CLK_PLL_MATCH ,to acquire the corresponding second sampled signal CAL_N<0>;the control block 902 determines the relationship between the duty cycle of the calibration clock signal CLK_X and the target duty cycle through the second sampled signal CAL_N<0>, and according to the relationship between the duty cycle of the calibration clock signal CLK_X and the target duty cycle generate the corresponding second calibration control signal CORR_C2 to the duty cycle calibration cell 10, that enable the duty cycle calibration cell 10 continuously adjusts the duty cycle of the input clock signal CLK_SCIN according to the second calibration control signal CORR_C2, thereby calibrating the duty cycle of the calibration clock signal CLK_X to the target duty cycle.

Please refer to FIG. 2, taking the first edge as the rising edge and the second edge as the falling edge as an example, the rising edge of the delay-matched clock signal CLK_PLL_MATCH is aligned with the rising edge of the second feedback clock signal CLK_RING2, and the second feedback clock signal CLK_RING2 has the target duty cycle. Therefore, using the falling edge of the second feedback clock signal CLK_RING2 performs the second sampling on the delay-matched clock signal CLK_PLL_MATCH, the acquired second sampled signal CAL_N<0> may have the following cases:
1) If the duty cycle of the delay-matched clock signal CLK_PLL_MATCH is the target duty cycle, then using the falling edge of the second feedback clock signal CLK_RING2 to perform a second sampling on the delay-matched clock signal CLK_PLL_MATCH, the sampled values of the acquired second sampled signal may be either the first value or the second value. For example, the first value is 0 and the second value is 1.
2) If the duty cycle of the delay-matched clock signal CLK_PLL_MATCH is less than the target duty cycle, then using the falling edge of the second feedback clock signal CLK_RING2 to perform sampling on the delay-matched clock signal CLK_PLL_MATCH, the sampled values of the acquired second sampled signal CAL_N<0> are all the first value.
3) If the duty cycle of the delay-matched clock signal CLK_PLL_MATCH is greater than the target duty cycle, then using the falling edge of the second feedback clock signal CLK_RING2 to perform sampling on the delay-matched clock signal CLK_PLL_MATCH, the sampled values of the acquired second sampled signal CAL_N<0> are all the second value.

It should be noted that in the first calibration stage, the sampling block 901 comprises the first D flip-flop 9011, the first D flip-flop 9011 uses the second feedback clock signal CLK_RING2 to perform a second sampling processing on the delay-matched clock signal CLK_PLL_MATCH, to acquire the corresponding second sampled signal CAL_N<0>.

Correspondingly, If when the sampled values of the second sampled signals CAL_N<0> acquired by control block 902 according to the preset second control period are all the first value, that can determine the duty cycle of the clock signal is less than the target duty cycle, at this time, output the corresponding second calibration control signal CORR_C2, that enable the duty cycle calibration cell 10 to increase the duty cycle of the calibration clock signal CLK_X; If when the sampled values of the second sampled signals CAL_N<0> acquired by control block 902 according to the preset second control period are all the second value, that can determine the duty cycle of the calibration clock signal CLK_X is greater than the target duty cycle, at this time, output the corresponding second calibration control signal CORR_C2, and enable the duty cycle calibration cell 10 to decrease the duty cycle of the calibration clock signal CLK_X; When the average of the sampled values of the second sampled signals CAL_N<0> acquired according to the preset control period is the average value of the first value and the second value, that can determine the duty cycle of the calibration clock signal CLK_X is equal to the target duty cycle, at this time, output the corresponding second calibration control signal CORR_C2, and enable the duty cycle calibration cell 10 to maintain the duty cycle of the calibration clock signal CLK_X unchanged.

Referring to FIG. 3, in this embodiment, the second calibration control signal CORR_C2 output by the control block 902 comprises multiple coarse adjustment step control signals S_H[I:0] one-to-one corresponding to multiple coarse adjustment steps and multiple fine adjustment step control signals S_L[J:0] one-to-one corresponding to multiple fine adjustment steps. Wherein, I and J are integers greater than or equal to 1, and the step interval between adjacent coarse adjustment steps is greater than the step interval between adjacent fine adjustment steps.

The control block 902 first outputs the coarse adjustment step control signals S_H[I:0], that enable the duty cycle calibration cell 10 to perform a second duty cycle calibration processing on the input clock signal CLK_SCIN according to the coarse adjustment step control signals S_H[I:0],until the duty cycle of the output calibration clock signal CLK_X oscillates back and forth around the target duty cycle; Afterwards, outputs the fine adjustment step control signal S_L[J:0], that enable the duty cycle calibration cell 10 to perform a second duty cycle calibration processing on the input clock signal CLK_SCIN according to the fine adjustment step control signals S _L[J:0],until the duty cycle of the output calibration clock signal CLK_X reaches the target duty cycle.

Firstly, using the coarse adjustment step control signals S _H[I:0] to perform a second duty cycle calibration processing, that enable the duty cycle of the calibration clock signal CLK_X converges to a smaller range, then using the fine adjustment step control signals S_L[J:0] to perform a second duty cycle calibration processing within this smaller range, that can enable the duty cycle of the calibration clock signal CLK_X to reach the target duty cycle quickly, can improve the speed of the second duty cycle calibration processing, reduce time for the first calibration phase, and help improve the calibration speed and efficiency of the clock duty cycle calibration circuit in the embodiments of the disclosure.

In this embodiment, the control block 902 further configured to, when performing a second duty cycle calibration processing on the input clock signal CLK_SCIN according to the second calibration control signal CORR_C2 until the duty cycle of the calibration clock signal CLK_X reaches a target duty cycle, acquire the corresponding coarse adjustment calibration control signals S _H[I:0] and the corresponding fine adjustment calibration control signals S_L[J:0] and store, further configured to, when receiving a wake-up signal, transmit the stored coarse adjustment calibration control signals S _H[I:0] and the fine adjustment calibration control signals S_L[J:0] to the duty cycle calibration cell 10 .

Correspondingly, the duty cycle calibration cell 10 further configured to, when receiving the coarse adjustment calibration control signals S _H[I:0] and the fine adjustment calibration control signals S_L[J:0] sent by the control block 902,calibrate the duty cycle of the calibration clock signal CLK_X to the target duty cycle according to the received coarse adjustment calibration control signals S _H[I:0] and the fine adjustment calibration control signals S_L[J:0].

In this embodiment, the corresponding coarse adjustment calibration control signals S _H[I:0],refers to during the process of performing the second duty cycle calibration processing on the input clock signal CLK_SCIN according to the coarse adjustment calibration control signals S_H[I:0],that enable when the duty cycle of the output calibration clock signal CLK_X oscillates back and forth near the target duty cycle, corresponding to the coarse adjustment calibration control signals; the corresponding fine adjustment calibration control signals S_L[J:0], refers to during the process of performing the second duty cycle calibration processing on the input clock signal CLK_SCIN according to the fine adjustment calibration control signal S_L[J:0],that enable when the duty cycle of the output calibration clock signal CLK_X reaches the target duty cycle, corresponding to the fine adjustment calibration control signals S_L[J:0].

Correspondingly, the control block 902 transmit the stored coarse adjustment calibration control signal S_H[I:0] and fine adjustment calibration control signal S_L[J:0] to the duty cycle calibration cell 10 when received a wake-up signal, that can enable the duty cycle calibration cell 10 to directly calibrate the duty cycle of the calibration clock signal CLK_X to a small range around the target duty cycle according to the corresponding fine adjustment calibration control signal S_L[J:0], can bypass previous other processing steps and help improve calibration speed. At the same time, performing the duty cycle adjusting on the input clock signal CLK_SCIN only during the wake-up phase, which help minimize power consumption.

It should be noted that in this embodiment, the phase-locked loop cell 70 further comprises: a third frequency divider block 706, configured to perform a third frequency division processing on the second oscillation clock signal CLK_OUT2, to acquire a third frequency-divided signal.

In this embodiment, the third frequency divider block 706 is provided with an input port and an output port. Wherein, the input port of the third frequency divider block 706 is coupled to the output port of the voltage-controlled oscillator cell 705, the output port of the third frequency divider block 706 is coupled to the calibration control cell 90. The third frequency divider block 706 configured to perform third frequency division processing on the second oscillation clock signal CLK_OUT2 , to acquire the third frequency-divided signal.

Correspondingly, the calibration control cell 90 further comprises: a timing control block 903, configured to perform a fifth delay processing on the delay-matched clock signal CLK_PLL_MATCH according to the third frequency-divided signal ,to acquire the second timing control signal CLK_DIG2, the frequency of the second timing control signal CLK_DIG2 is higher than the frequency of the feedback clock signal CLK_RING, and the phase of the second timing control signal CLK_DIG2 lags behind the phase of the second feedback clock signal CLK_RING2.

Specifically, the timing control block 903 is provided with a control port, an input port and an output port. Wherein, the control port of the timing control block 903 configured to receive the third frequency-divided signal, the input port of the timing control block 903 configured to receive the delay-matched clock signal CLK_PLL_MATCH, the output port of the timing control block 903 is coupled to the control block 902.The timing control block 903 configured to perform a fifth delay processing on the delay-matched clock signal CLK_PLL_MATCH according to the third frequency-divided signal, to acquire the second timing control signal CLK_DIG2.

In this embodiment, the timing control block 903 comprises a time delay cell. Correspondingly, the control block 902 further configured to control the output timing of the second calibration control signal CORR_C2 according to the second timing control signal CLK-DIG2.

The frequency of the second timing control signal CLK_DIG2 is higher than the frequency of the second feedback clock signal CLK_RING2, and the phase of the second timing control signal CLK_DIG2 lags behind the phase of the second feedback clock signal CLK_RING2,that can enable the arrival time of the rising edge of the second timing control signal CLK_DIG2 is much slower than the arrival time of the rising edge of the delay-matched clock signal CLK_PLL_MATCH, thereby using the second timing control signal CLK_DIG2 to control the output timing of the second calibration control signal CORR_C2, that can improve the accuracy of the output second calibration control signal CORR_C2 and further help achieve the accurate control of the duty cycle calibration cell 10.

During the first calibration phase, the clock duty cycle calibration circuit in this embodiment of the disclosure can perform real-time calibration of the duty cycle of the calibration clock signal CLK_X, overcome the duty cycle offset of the calibration clock signal CLK_X caused by process, voltage, and temperature (PVT),enable the duty cycle of the calibration clock signal CLK_X to meet the target duty cycle, that can improve the accuracy of the generated calibration clock signal CLK_X.

When performing a second duty cycle calibration processing on the input clock signal CLK_SCIN according to the second calibration control signal CORR_C2 to enable the duty cycle of the output calibration clock signal CLK_X reaches the target duty cycle, the calibration control cell 90 converts the logic level of the reference selection control signal PLL_REF_SL from the first level to the second logic level, and enable the clock duty cycle calibration circuit in the embodiment of the disclosure to enter the second calibration stage. Specifically:
In the duty cycle calibration cell 10, using the first delay block 101 to perform the first delay processing on the input clock signal CLK_SCIN, to acquire the first delayed clock signal, and the first OR operation block 102 performs OR operation processing on the input clock signal CLK_SCIN and the first delayed clock signal, to acquire the summed clock signal CLK_ADD, that enable the duty cycle of the summed clock signal CLK_ADD further to increase, then, the first inverter 103 configured to perform inversion processing on the summed clock signal, to acquire the inverted signal CLK_IN of the summed clock signal.

Next, by the second delay block 104 in the duty cycle calibration cell 10 receiving the inverted signal CLK_IN of the summed clock signal, and performing a second delay processing on the inverted signal CLK_IN of the summed clock signal according to the first calibration control signal CORR_C1,to acquire the second delay clock signal, and by the second OR operation block 105 performing OR operation on the inverted signal CLK_IN of the summed clock signal and the second delay clock signal, to acquire the calibration clock signal CLK_X.

Subsequently, using the delay matching cell 30, the frequency multiplied clock signal 50, the phase-locked loop cell 70 and the calibration control cell 90, can real-time acquire the relationship between the actual duty cycle of the calibration clock signal CLK_X output by the duty cycle calibration cell 10 and the target duty cycle, and generate the corresponding first calibration control signal CORR_C1, to maintain the duty cycle of the calibration clock signal CLK_X at the target duty cycle.

Specifically, by the delay matching cell 30 performing delay matching processing on the calibration clock signal CLK_X, to acquire the delay-matched clock signal CLK_PLL_MATCH. The first edge of the delay-matched clock signal CLK_PLL_MATCH is aligned with the first edge of the calibration clock signal CLK_X, and the delay-matched clock signal CLK_PLL_MATCH has the same duty cycle as the calibration clock signal CLK_X.

At the same time, using the signal frequency multiplier cell 50 to perform frequency multiplication processing on the calibration clock signal CLK_X, to acquire the frequency-multiplied clock signal CLK_NX. Wherein, the first edge of the frequency-multiplied clock signal CLK_NX is aligned with the first edge of the calibration clock signal CLK_X, and the frequency of the frequency-multiplied clock signal CLK_NX is N times that of the frequency of the calibration clock signal CLK_X.

In this embodiment, N is equal to 2, which means that the first edge of the frequency-multiplied clock signal CLK_NX is aligned with the first edge of the calibration clock signal CLK_X, and the frequency-multiplied clock signal CLK_NX is twice that of the frequency of the calibration clock signal CLK_X.

Correspondingly, in the signal frequency multiplier cell 50, first, using the third delay block 501 to perform third delay processing on the calibration clock signal CLK_X, to acquire the third delayed clock signal, then, using the XOR operation block 502 to perform XOR operation processing on the calibration clock signal CLK_X and the third delayed clock signal, to acquire the frequency-multiplied clock signal CLK_NX.

In the second calibration stage, the reference selection control signal PLL_REF_SEL has a second logic level. Correspondingly, the data strobe cell 55 selects and outputs the frequency-multiplied clock signal CLK_NX output by the output port of the signal frequency multiplier cell 50 to phase-locked loop cell 70.

In the phase-locked loop cell 70, using the phase-frequency detector block 701 to acquire the first phase difference signal according to the phase difference between the frequency-multiplied clock signal CLK_NX and the first feedback clock signal CLK_RING1, and the charge pump block 702 converts the first phase difference signal into the first current signal, then using the loop filter block 703 to perform low-pass filter processing on the first current signal, then the voltage-controlled oscillator block 704 acquires the first oscillation clock signal CLK_OUT1 according to the low-pass filtered first current signal output by the loop filter block 703.The first frequency divider block 705 performs the first frequency division processing on the first oscillation clock signal CLK_OUT1 output by the voltage-controlled oscillator block 704,to acquire the corresponding first feedback clock signal CLK_RING1.In this way, the loop repeats until the phase-locked loop cell 70 enters the first locked state.

Wherein, when the phase-locked loop cell 70 is in the first locked state, the first edge of the first feedback clock signal CLK_RING1 is aligned with the first edge of the frequency-multiplied clock signal CLK_NX, and the frequency of the first feedback clock signal CLK_RING1 is the same as that of the frequency-multiplied clock signal CLK_NX.

Correspondingly, the calibration control cell 90 utilizes the relationship between first feedback clock signal CLK_RING1 output by the phase-locked loop cell 70 when in the first locked state and the frequency-multiplied clock signal CLK_NX, the relationship between the delay-matched clock signal CLK_PLL_MATCH output by the delay matching cell 30 and the calibration clock signal CLK_X, and the relationship between the frequency-multiplied clock signal CLK_NX and the calibration clock signal CLK_X, by using the second edge of the first feedback clock signal CLK_RING1 output by the phase-locked loop cell 70 in the first locked state and the adjacent next first edge to respectively perform the first sampling processing on the delay-matched clock signal CLK_PLL_MATCH output by the delay matching cell 30, can acquire the relationship between the duty cycle of the delay-matched clock signal CLK_PLL_MATCH and the target duty cycle.

At the same time, the duty cycle of the delay-matched clock signal CLK_PLL_MATCH is the same as the duty cycle of the calibration clock signal CLK_X, so the relationship between the duty cycle of the delay-matched clock signal CLK_PLL_MATCH and the target duty cycle of the first feedback clock signal CLK_RING1, which means that the relationship between the duty cycle of the calibration clock signal CLK_X and the target duty cycle, thereby generating the corresponding first calibration control signal CORR_C1 to the duty cycle calibration cell 10 according to the relationship between the duty cycle of the calibration clock signal CLK_X and the target duty cycle, that can maintain the duty cycle calibration of the calibration clock signal CLK_X at the target duty cycle.

Specifically, the sampling block 901 uses the first feedback clock signal CLK_RING to perform the first sampling processing on the delay-matched clock signal CLK_PLL_MATCH, to acquire the corresponding first sampled signal. Afterwards, the control block 902 determines the relationship between the duty cycle of the calibration clock signal CLK_X and the target duty cycle by the first sampled signal, and generates the corresponding first calibration control signal CORR_C1 to the duty cycle calibration cell 10 according to the relationship between the duty cycle of the calibration clock signal CLK_X and the target duty cycle, that enable the duty cycle calibration cell 10 adjusts the duty cycle of the input clock signal CLK_SCIN according to the first calibration control signal CORR_C1, thereby maintaining the duty cycle of the calibration clock signal CLK_X at the target duty cycle.

Specifically, when the phase-locked loop cell 701 is in the first locked state, in the sampling block 901: The first D flip-flop 9011 performs the first sub sampling processing on the delay-matched clock signal CLK_PLL_MATCH when the second edge of the first feedback clock signal CLK_RING1 arrives, to acquire the first sub sampled signal CAL_N<1>; The second D flip-flop 9012 performs the second sub sampling process on the delay-matched clock signal CLK_PLL_MATCH after acquiring the first sub sampled signal CAL_N<1> and when the first edge of the first feedback clock signal CLK_RING1 arrives, to acquire the second sampled signal CAL_P<0>; The third D flip-flop 9013 transmits the first sub sampled signal CAL_N<1> to the control cell 902 after acquiring the second sampled signal CAL_P<0> and when the second edge of the first feedback clock signal CLK_RING1 arrives; The fourth D flip-flop 9014 transmits the second sampled signal CAL_P<0> to the control cell 902 after acquiring the second sampled signal CAL_P<0> and when the second edge of the first feedback clock signal CLK_RING1 arrives.

It should be noted that the presence of the third D flip-flop 9013 and the fourth D flip-flop 9014, that enable the first sub sampled signal CAL_N<1> and the second sub sampled signal CAL_P<0> are synchronously transmitted to the control block 902.

When the phase-locked loop cell 70 is in the first locked state, the first edge of the first feedback clock signal CLK_RING1 has the same frequency as the frequency-multiplied clock signal CLK_NX input to the phase-locked loop cell 70, and the first edge of the first feedback clock signal CLK_RING1 is aligned with the first edge of the frequency-multiplied clock signal CLK_NX. At the same time, the first edge of the delay-matched clock signal CLK_PLL_MATCH aligns with the first edge of the calibration clock signal CLK_X, and the duty cycle of the delay-matched clock signal CLK_PLL_MATCH is the same as the duty cycle of the calibration clock signal CLK_X.

Please refer to FIG. 2, taking the first edge as the rising edge and the second edge as the falling edge as an example, using the falling edge of the first feedback clock signal CLK_RING1 and the adjacent next rising edge to perform the first sampling processing on the delay-matched clock signal CLK_PLL_MATCH, the acquired sampled value of the first sub sampled signal CAL_N<1> and the second sub sampled signal CAL_P<0> ,may have the following cases:
1) If the duty cycle of the delay-matched clock signal CLK_PLL_MATCH is less than the target duty cycle, using the falling edge of the first feedback clock signal CLK_RING1 and the adjacent next rising edge to perform the second sampling on the delay-matched clock signal CLK_PLL_MATCH, the acquired sampled value of the first sub sampled signal CAL_N<1> and the acquired sampled value of the second sub sampled signal CAL_P<0> are the second sampled value and the first sampled value, respectively;
2) If the duty cycle of the delay-matched clock signal CLK_PLL_MATCH is less than the target duty cycle, using the falling edge of the first feedback clock signal CLK_RING1 and the adjacent next rising edge to perform the second sampling on the delay-matched clock signal CLK_PLL_MATCH, the acquired sampled value of the first sub sampled signal CAL_N<1> and the acquired sampled value of the second sub sampled signal CAL_P<0> are all the second sampled value, wherein, the first sampled value is 0, the second sampled value is 1.

Correspondingly, control block 902 can determine the relationship between the duty cycle of delay-matched clock signal CLK_PLL_MATCH and the target duty cycle according to the first sub sampled signal CAL_N<1> and the second sub sampled signal CAL_P<0>, thereby generating corresponding first calibration control signal CORR_C1.

Specifically, if the control block 902 acquires the sampled values of the first sub sampled signal CAL_N<1> and the sampled values of the second sub sampled signal CAL_P<0> according to the preset first control period are the second sampled value and the first sampled value, respectively, that can determine the duty cycle of the calibration clock signal is less than the target duty cycle, at this time, output the corresponding first calibration control signal CORR_C1,enable the duty cycle calibration cell 10 to increase the duty cycle of the calibration clock signal CLK_X; if the control block 902 acquires the sampled values of the first sub sampled signal CAL_N<1> and the sampled values of the second sub sampled signal CAL_P<0> according to the preset first control period are all the second sampled value, that can determine the duty cycle of the calibration clock signal is greater than the target duty cycle, at this time, output the corresponding first calibration control signal CORR_C1, enable the duty cycle calibration cell 10 to reduce the duty cycle of the calibration clock signal CLK_X.

In this embodiment, the first calibration control signal CORR_C1 comprises multiple fine adjustment step control signals one-to-one corresponding to multiple fine adjustment steps. Correspondingly, the control cell 902 further configured to generate the fine adjustment step control signals corresponding to the fine adjustment steps and output it to the duty cycle calibration cell according to the first sampled signals when the phase-locked loop cell is in the first locked state.

Wherein, regarding the fine adjustment steps and the fine adjustment step control signals, their implementation may reference the content of the fine adjustment steps and the fine adjustment step control signals in the first calibration stage, which will not be further elaborated herein.

It should be noted that, in this embodiment, in the first calibration stage, the phase-locked loop cell 70 further comprises: a third frequency divider block 706, further configured to perform a third frequency division processing on the first oscillation clock signal CLK_OUT_1, to acquire the third frequency-divided signal.

Correspondingly, the calibration control cell 90 further comprises: a timing control cell 903, configured to perform a fourth delay processing on the delay-matched clock signal CLK_PLL_MATCH according to the third frequency-divided signal, to acquire the first timing control signal CLK_DIG1,the frequency of the first timing control signal CLK_DIG1 is higher than that of the first feedback clock signal CLK_RING1, and the phase of the first timing control signal CLK_DIG1 lags behind the phase of the first feedback clock signal CLK_RING1.

Specifically, by the third frequency divider cell 706 in the phase-locked loop cell 70 and the timing control cell 903 in the calibration control cell 90, can generate a first timing control signal CLK_DIG1 with a frequency much higher than that of the first feedback clock signal CLK_RING1 and a phase lagging behind the phase of the first feedback clock signal CLK_RING1, thereby using the first timing control signal CLK_DIG1 to control the output timing of the first calibration control signal CORR_C1, that can improve the accuracy of the output first calibration control signal CORR_C1, which helps achieve accurate control of the duty cycle calibration cell 10.

Regarding the third frequency divider cell 706 and the timing control cell 903, please refer to the corresponding descriptions in the first calibration phase, which will not be further elaborated herein.

During the second calibration stage, the clock duty cycle calibration circuit in the embodiment of the disclosure, can overcome the duty cycle offset caused by the operating temperature, and maintain the duty cycle of the calibration clock signal CLK_X at the target duty cycle, that can improve the accuracy of the generated calibration clock signal CLK_X.

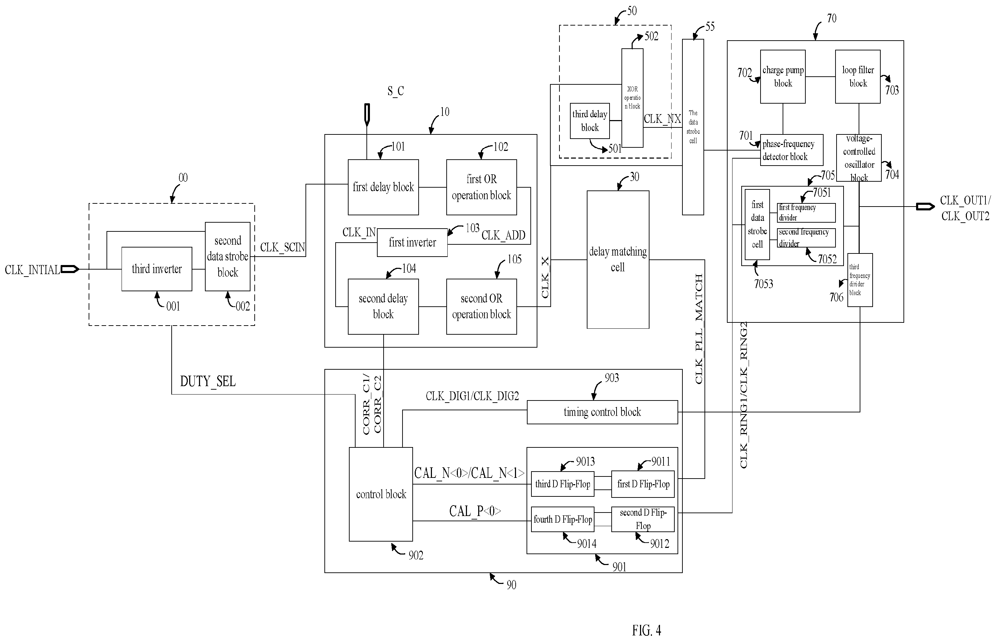

FIG. 4 is a circuit structure diagram in the second embodiment of the duty cycle calibration circuit provided by the technical solution of the disclosure. The similarities between this embodiment and the first embodiment, which will not be further elaborated herein. The differences between this embodiment and the first embodiment are as follows: the clock duty cycle calibration circuit also comprises: a signal selection cell 00, configured to ,before performing a second duty cycle calibration processing on the input clock signal CLK_SCIN according to the second calibration control signal CORR_C2 until the duty cycle of the calibration clock signal CLK_X reaches the target duty cycle, output the initial clock signal CLK_INITIAL with a duty cycle greater than the target duty cycle or the inverted signal of the initial clock signal according to the duty cycle selection control signal DUTY_SEL as the input clock signal CLK_SCIN.

Correspondingly, the delay matching cell 30 further configured to perform initial delay matching processing on the initial clock signal CLK_INITIAL, to acquire the initial delay-matched signal, the first edge of the initial delay-matched clock signal is aligned with the first edge of the initial clock signal, and the delay-matched clock signal has the same duty cycle as the initial clock signal; The phase-locked loop cell 70 further configured to perform initial phase-locked processing on the initial clock signal CLK _INITIAL, to acquire the initial oscillation clock signal; Performing initial frequency division processing on the initial oscillation clock signal, to acquire the initial feedback clock signal; Wherein ,when the phase-locked loop cell 70 is in the initial locked state, the first edge of the initial feedback clock signal is aligned with the first edge of the initial delay-matched clock signal and has the target duty cycle; The calibration control cell 90 further configured to perform initial sampling processing on the initial delay-matched clock signal using the initial feedback clock signal when the phase-locked loop cell is in the initial locked state, to acquire the initial sampled signal, the initial sampled signal configured to instruct the relationship between the duty cycle of the initial clock signal and the target duty cycle; According to the initial sampled signal, generate a duty cycle selection control signal.

In this embodiment, the signal selection cell 00 is provided with an control port, an input port and an output port. Wherein, the control port of signal selection cell 00 is coupled to calibration control cell 90, the input port of signal selection cell 00 is used to receive the initial clock signal CLK_INITIAL, the output port of signal selection cell 00 is coupled to duty cycle calibration cell 10. The signal selection cell 00 configured to, before performing a second duty cycle calibration processing on the input clock signal CLK_SCIN according to the second calibration control signal CORR_C2 until the duty cycle of the calibration clock signal CLK_X reaches the target duty cycle, output the initial clock signal CLK_INITIAL with a duty cycle greater than the target duty cycle or the inverted signal of the initial clock signal according to the duty cycle selection control signal DUTY_SEL as the input clock signal CLK_SCIN.

In this embodiment, signal selection cell 00 configured to, when the duty cycle selection control signal DUTY_SEL has a first logic level, select the output the initial clock signal CLK_INITIAL as the input clock signal; and when the duty cycle selection control signal DUTY_SEL has a second logic level, select and output the inverted signal of the initial clock signal as the input clock signal CLK_SCIN.

Specifically, the signal selection cell 00 comprises a third inverter 001 and a second data strobe block 002.Wherein:
The third inverter 001 is provided with an input port and an output port. Wherein, the input port of the third inverter 001 is used to receive the initial clock signal CLK _INITIAL, the output port of the third inverter 001 is coupled to the first input port of the second data strobe block 002.The third inverter 001 configured to perform the inversion processing on the initial clock signal CLK _INITIAL, to acquire the inverted signal of the initial clock signal.

The second data strobe block 002 is provided with a control port, a first input port, a second input port and an output port. Wherein, the control port of the second data strobe block 002 is coupled to the calibration control cell 90, the first input port of the second data strobe block 002 is used to receive the initial clock signal CLK _INITIAL, the second input port of the second data strobe block 002 is coupled to the output port of the third inverter 001, the output port of the second data strobe block 002 is used as the output port of signal selection cell 00 or coupled to the output port of signal selection cell 00. The data strobe block 002 configured to select the signal with a duty cycle greater than the target duty cycle from the initial clock signal CLK_INITIAL and the inverted signal of the initial clock signal as the input clock signal CLK_SCIN and output it according to duty cycle selection control signal DUTY_SEL.

In other embodiments, the signal selection cell may also be implemented through other structures with the same functions. Those skilled in the art may select according to actual needs, which will not be limited herein.

Correspondingly, the calibration control cell 90 further configured to generate a mode selection control signal S_C with a first logic level before generating the duty cycle selection control signal DUTY_SEL; and to generate a mode selection control signal S_C with a second logic level after generating the duty cycle selection control signal DUTY_SEL. For example, the first logic level is logic high level, the second logic level is logic low level.

Correspondingly, duty cycle calibration cell 10 configured to, when the mode selection control signal DUTY_SEL has a second logic level, perform the second duty cycle calibration processing on the input clock signal CLK_SCIN according to the second calibration control signal CORR_C2,until the duty cycle of the output calibration clock signal CLK_X reaches the target duty cycle; and further configured to, after performing a second duty cycle calibration processing on the input clock signal CLK_SCIN when the mode selection control signal DUTY_SEL has a second logic level and according to the second calibration control signal CORR_C2,until after the duty cycle of the output calibration clock signal CLK_X reaches the target duty cycle, perform a first duty cycle calibration processing on the input clock signal CLK_SCIN according to the first calibration control signal CORR_C1,until the duty cycle of the output calibration clock signal CLK_X reaches the target duty cycle; and further configured to, when the mode selection control signal DUTY_SEL has a first logic level, pass the initial clock signal CLK_INITIAL through to the phase-locked loop cell 70 and the delay matching cell 30.

In this embodiment, after the duty cycle calibration cell 10 pass the initial clock signal CLK_INITIAL through to the delay matching cell 30 and the phase-locked loop cell 70, using the delay matching cell 30, the phase-locked loop cell 70 and the calibration control cell 90 can acquire the relationship between the duty cycle of the initial clock signal CLK_INITIAL and the target duty cycle, thereby generating a corresponding duty cycle selection control signal DUTY_SEL to the signal selection cell 00 according to the relationship between the duty cycle of the initial clock signal CLK_INITIAL and the target duty cycle, that enable the signal selection cell 00 to select output the initial clock signal CLK_INITIAL with a duty cycle greater than the target duty cycle, or the inverted signal of the initial clock signal as the input clock signal CLK_SCIN according to the duty cycle selection control signal DUTY_SEL.

Regarding the process of using the delay matching cell 30, phase-locked loop cell 70, and calibration control cell 90 to acquire the relationship between the duty cycle of the initial clock signal CLK_INITIAL and the target duty cycle, and generating the corresponding duty cycle selection control signal DUTY_SEL according to the relationship between the duty cycle of the initial clock signal CLK_INITIAL and the target duty cycle, can refer to the description of the process in the aforementioned embodiment that using the delay matching cell 30, Phase-Locked Loop cell 70, and Calibration Control cell 90 to acquire the relationship between the duty cycle of the calibration clock signal CLK_X and the target duty cycle, and generating the corresponding second calibration control signal CORR_C2 according to the relationship between the duty cycle of the calibration clock signal CLK_X and the target duty cycle, and execute it, which will not be further elaborated herein.

In this embodiment, the calibration control cell 90 further configured to, when determining that the duty cycle of the initial clock signal is greater than the target duty cycle and the duty cycle selection control signal has the second logic level, convert the logic level of the duty cycle selection control signal from the first logic level to the second logic level, and when waiting for the phase-locked loop cell reenters the initial locked state, convert the logic level of the mode selection control signal from the first logic level to the second logic level.

The calibration control cell 90 configured to, when determining that the duty cycle of the initial clock signal is greater than the target duty cycle and the duty cycle selection control signal has a second logic level, converts the logic level of the duty cycle selection control signal from the first logic level to the second logic level, may cause jitter in the initial clock signal CLK_INITIAL input to the phase-locked loop cell 70. Therefore, waiting for the phase-locked loop cell 70 to reenter the initial locking state, that can enable the first edge of the initial feedback clock signal output by the phase-locked loop cell 70 to realign with the first edge of the initial clock signal CLK_INITIAL. At this time, converting the logic level of the mode selection control signal S_C from the first logic level to the second logic level, thereby entering the first calibration stage and the second calibration stage.

It should be noted that in this embodiment, the clock duty cycle calibration circuit uses the signal selection cell 00 to transmit the initial clock signal CLK_INITIAL with a duty cycle greater than the target duty cycle or the inverted signal of the initial clock signal to duty cycle calibration cell 10 according to the duty cycle selection control signal, subsequently, increasing the duty cycle and inverted in the duty cycle calibration cell 10, that enable the duty cycle of the inverted signal CLK_IN of the summed clock signal entering the second delay block 104 is less than the target duty cycle, and has a larger adjustment margin, this provides the foundation for subsequent continuous adjustment toward increasing the duty cycle of the inverted signal CLK_IN of the summed clock signal, until the output calibration clock signal CLK_X reaches the target duty cycle.

It should also be noted that in other embodiments, also can enable the duty cycle of the inverted signal CLK_IN of the summed clock signal greater than the target duty cycle, and continuously adjusting toward reducing the duty cycle of the inverted signal CLK_IN of the summed clock signal, until the output calibration clock signal CLK_X reaches the target duty cycle.

Correspondingly, a clock duty cycle calibration method is also provided in the embodiments of the disclosure.

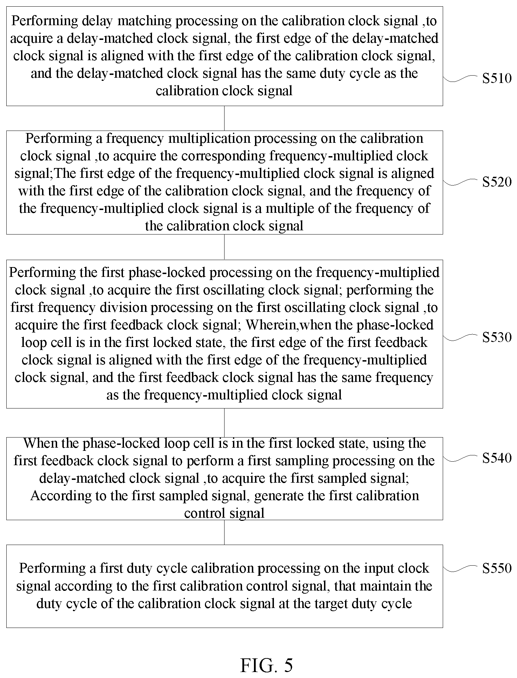

FIG. 5 is a schematic flowchart in an embodiment of a clock duty cycle calibration method provided by the technical solution of the disclosure. Refer to FIG. 5, a clock duty cycle calibration method, specifically comprises the following steps:
S510: Performing delay matching processing on the calibration clock signal, to acquire a delay-matched clock signal, the first edge of the delay-matched clock signal is aligned with the first edge of the calibration clock signal, and the delay-matched clock signal has the same duty cycle as the calibration clock signal;
S520: Performing a frequency multiplication processing on the calibration clock signal, to acquire the corresponding frequency-multiplied clock signal; The first edge of the frequency-multiplied clock signal is aligned with the first edge of the calibration clock signal, and the frequency of the frequency-multiplied clock signal is a multiple of the frequency of the calibration clock signal;
S530: Performing the first phase-locked processing on the frequency-multiplied clock signal ,to acquire the first oscillating clock signal; performing the first frequency division processing on the first oscillating clock signal ,to acquire the first feedback clock signal; Wherein, when the phase-locked loop cell is in the first locked state, the first edge of the first feedback clock signal is aligned with the first edge of the frequency-multiplied clock signal, and the first feedback clock signal has the same frequency as the frequency-multiplied clock signal;
S540: When the phase-locked loop cell is in the first locked state, using the first feedback clock signal to perform a first sampling processing on the delay-matched clock signal, to acquire the first sampled signal; According to the first sampled signal, generate the first calibration control signal;
S550: Performing a first duty cycle calibration processing on the input clock signal according to the first calibration control signal, that maintain the duty cycle of the calibration clock signal at the target duty cycle;

The clock duty cycle calibration method in the embodiments of the disclosure can be implemented by the clock duty cycle calibration circuit in the embodiments of the disclosure, or other functional modules can also be used to implement the clock duty cycle calibration method in the embodiments of the disclosure. About the clock duty cycle calibration circuit in the embodiments of the disclosure, please refer to the detailed descriptions in the preceding section, which will not be further elaborated herein.

Correspondingly, a clock multiplier circuit is further provided in an embodiment of the disclosure, the clock multiplier circuit comprises the clock duty cycle calibration circuit provided in the embodiments of the disclosure.

When the duty cycle of the calibration clock signal reaches 50%, the clock multiplier circuit in the embodiments of the disclosure can overcome the duty cycle offset of the calibration clock signal caused by operating temperature, maintain the duty cycle of the calibration clock signal at 50%, that enable the frequency-multiplied clock signal generated based on the calibration clock signal to have a single time period, that can improve the accuracy of the generated frequency-multiplied clock signal, consequently help improve the quality of wireless communication.

About the clock duty cycle calibration circuit in the embodiments of the disclosure, please refer to the detailed descriptions in the preceding section, which will not be further elaborated herein.

Although the embodiments of the disclosure are disclosed above, the disclosure is not limited thereto. Those skilled in the art can make various alterations and modifications without departing from the spirit and scope of the disclosure. Therefore, the scope of protection of the disclosure should be subject to the scope defined in the claims.

## Claims

1. A clock duty cycle calibration circuit, comprising:
a duty cycle calibration cell, configured to perform the first duty cycle calibration processing on the input clock signal according to the first calibration control signal, to maintain the duty cycle of the calibration control signal at the target duty cycle;
a delay matching cell, configured to perform delay matching processing on the calibration clock signal, to acquire a delay-matched clock signal, the first edge of the delay-matched clock signal is aligned with the first edge of the calibration clock signal, and the delay-matched clock signal has the same duty cycle as the calibration control signal;
a signal frequency multiplier cell, configured to perform frequency multiplication processing on the calibration clock signal, to acquire the corresponding frequency-multiplied clock signal, the first edge of the frequency-multiplied clock signal is aligned with the first edge of the calibration clock signal, and the frequency of the frequency-multiplied clock signal is a multiple of the frequency of the calibration clock signal;
a phase-locked loop cell, configured to perform the first phase-locked processing on the frequency-multiplied clock signal ,to acquire the first oscillating clock signal; and perform the first frequency division processing on the first oscillating clock signal ,to acquire the first feedback clock signal; Wherein, when the phase-locked loop cell is in the first locked state, the first edge of the first feedback clock signal is aligned with the first edge of the frequency-multiplied clock signal, and the first feedback clock signal has the same frequency as the frequency-multiplied clock signal;
a calibration control cell, configured to, when the phase-locked loop cell is in the locked state, perform a first sampling processing on delay-matched clock signal using the first feedback clock signal, to acquire the first sampled signal; According to the first sampled signal, generate the first calibration control signal.

2. The clock duty cycle calibration circuit according to claim 1, wherein the duty cycle calibration cell comprises:
a first delay block, configured to perform the first delay processing on the input clock signal, to acquire a first delay clock signal;
a first OR operation block, configured to perform OR operations processing on the input clock signal and the first delay clock signal, to acquire the summed clock signal;
a first inverter, configured to perform inversion processing on the summed clock signal ,to acquire the inverted signal of the summed clock signal;
a second delay block, configured to perform a second delay processing on the inverted signal of the summed clock signal according to the first calibration control signal, to acquire a second delay clock signal;
a second OR operation block, configured to perform OR operation processing on the inverted signal of the summed clock signal and the second delay clock signal, to acquire the calibration clock signal.

3. The clock duty cycle calibration circuit according to claim 1, wherein the signal frequency multiplier cell comprises:
a third delay block, configured to perform a third delay processing on the calibration clock signal, to acquire a third delay clock signal;
a XOR operation block, configured to perform XOR operation processing on the calibration clock signal and the third delay clock signal, to acquire the frequency-multiplied clock signal.

4. The clock duty cycle calibration circuit according to claim 1, wherein the phase-locked loop cell comprises:
a phase-frequency detector block, configured to acquire the first phase difference signal according to the phase difference between the frequency-multiplied clock signal and the first feedback clock signal;
a charge pump block, configured to convert the first phase difference signal into a first current signal;
a loop filter block, configured to perform low-pass filter processing on the first current signal;
a voltage-controlled oscillator block, configured to acquire the first oscillation clock signal according to the first current signal;
a first frequency divider block, configured to perform the first frequency division processing on the first oscillating clock signal, to acquire the first feedback clock signal.

5. The clock duty cycle calibration circuit according to claim 4, wherein the first frequency divider block comprises at least one of:
a first frequency divider, configured to perform the first sub frequency division processing on the first oscillating clock signal, to acquire the first frequency-divided signal;
a second frequency divider, configured to perform the second sub frequency division processing on the first frequency-divided signal, to acquire the first feedback clock signal.

6. The clock duty cycle calibration circuit according to claim 1, wherein the first calibration control signal comprises multiple fine adjustment step control signals one-to-one corresponding to multiple fine adjustment steps;
the calibration control cell, configured to, when the phase-locked loop cell is in the first locked state, generate a fine adjustment step control signal corresponding to the corresponding fine adjustment step according to the first sampled signal and output to the duty cycle calibration cell.

7. The clock duty cycle calibration circuit according to claim 1, wherein the calibration control cell comprises:
a sampling block, configured to, when the phase-locked loop cell is in the first locked state, perform the first sampling processing on the delay-matched clock signal using the first feedback clock signal, to acquire the sampled signal;
a control block, configured to generate the first calibration control signal according to the first sampled signal.

8. The clock duty cycle calibration circuit according to claim 7, wherein the sampling block comprises:
a first D Flip-Flop, configured to, when the second edge of the first feedback clock signal arrives, perform a first sub sampling processing on the delay-matched clock signal, to acquire the first sub sampled signal; a second D Flip-Flop, configured to, after acquiring the first sub sampled signal and when the first edge of the first feedback clock signal arrives, perform a second sub sampling processing on the delay-matched clock signal, to acquire the second sub sampled signal; a third D Flip-Flop, configured to, after acquiring the second sub sampled signal and when the second edge of the first feedback clock signal arrives, transmit the first sub sampled signal to the control block; a fourth D Flip-Flop, configured to, after acquiring the second sub sampled signal and when the second edge of the first feedback clock signal arrives, transmit the second sub sampled signal to the control block;
the control block, configured to generate the first calibration control signal according to the first sub sampled signal and the second sub sampled signal.

9. The clock duty cycle calibration circuit according to claim 1, wherein the phase-locked loop cell, configured to perform the third frequency division processing on the first oscillating clock signal, to acquire the third frequency-divided signal;
the calibration control cell, configured to perform a fourth delay processing on the delay-matched clock signal, to acquire the first timing control signal according to the third frequency-divided signal, the frequency of the first timing control signal is higher than the frequency of the first feedback clock signal, and the phase of the first timing control signal lags behind the phase of the first feedback clock signal; according to the first timing control signal, control the output timing of the first calibration control signal.

10. The clock duty cycle calibration circuit according to claim 1, wherein the duty cycle calibration cell is further configured to, before performing a first duty cycle calibration processing on the input clock signal according to the first calibration control signal to maintain the duty cycle of the calibration control signal at the target duty cycle, perform a second duty cycle calibration processing on the input clock signal according to the second calibration control signal until the duty cycle of the calibration clock signal reaches the target duty cycle;
the phase-locked loop cell is further configured to perform a second phase-locking processing on the calibration clock signal, to acquire a second oscillation clock signal; and perform a second frequency division process on the second oscillation clock signal, to acquire a second feedback clock signal; wherein, when the phase-locked loop cell is in the second locked state, the first edge of the second feedback clock signal is aligned with the first edge of the calibration clock signal, and the second feedback clock signal has the target duty cycle;
the calibration control cell is further configured to, when the phase-locked loop cell is in the second locked state, perform a second sampling process on the delay-matched clock signal using the second feedback clock signal, to acquire a second sampled signal; according to the second sampled signal, to generate the second calibration control signal.

11. The clock duty cycle calibration circuit according to claim 12, wherein the calibration control cell is further configured to, during the process of performing a second duty cycle calibration processing on the input clock signal according to the second calibration control signal until the duty cycle of the calibration clock signal reaches the target duty cycle, generate a reference selection control signal with a first logic level; then after performing a second duty cycle calibration processing on the input clock signal according to the second calibration control signal until the duty cycle of the calibration clock signal reaches the target duty cycle, convert the logic level of the reference selection control signal from the first logic level to the second logic level;
the clock duty cycle calibration circuit further comprises: a data strobe cell, configured to, when receiving a reference selection control signal with a first logic level, select and output the calibration clock signal to the phase-locked loop cell; and when receiving a reference selection control signal with a second logic level, select and output the frequency-multiplied clock signal to the phase-locked loop cell;
the phase-locked loop cell further comprising: a first data strobe block, configured to, when receiving a reference selection control signal with a first logic level, select and output the first feedback clock signal to the calibration control cell; and when receiving a reference selection control signal with a first logic level, select and output the second feedback clock signal to the calibration control cell;

12. The clock duty cycle calibration circuit according to claim 11, wherein the second calibration control signal comprises multiple coarse adjustment step control signals one-to-one corresponding to multiple coarse adjustment steps and multiple fine adjustment step control signals one-to-one corresponding to multiple fine adjustment steps, and the step interval between adjacent coarse adjustment step is greater than the step interval between adjacent fine adjustment step;
the calibration control cell is configured to generate a coarse adjustment step control signal corresponding to the coarse adjustment step according to the second sampled signal and output to the duty cycle calibration cell, until the duty cycle of the calibration clock signal oscillates back and forth near the target duty cycle; and further configured to, after the duty cycle of the calibration clock signal oscillates back and forth around the target duty cycle, generate a coarse adjustment step control signal corresponding to the corresponding fine adjustment step according to the second sampled signal and output to the duty cycle calibration cell , until the duty cycle of the calibration clock signal reaches the target duty cycle.

13. The clock duty cycle calibration circuit according to any one of claims 1 to 12, wherein it further comprises:
a signal selection cell, configured to, before performing a second duty cycle calibration processing on the input clock signal according to the second calibration control signal until the duty cycle of the calibration clock signal reaches the target duty cycle, select and output the initial clock signal with a duty cycle greater than the target duty cycle or the inverted signal of the initial clock signal according to the duty cycle selection control signal as the input clock signal;
the delay matching cell, further configured to perform initial delay matching processing on the initial clock signal, to acquire an initial delay-matched signal, the first edge of the initial delay-matched clock signal is aligned with the first edge of the initial clock signal, and the delay-matched clock signal has the same duty cycle as the initial clock signal;
the phase-locked loop cell, further configured to perform a initial phase-locked processing on the initial clock signal, to acquire the initial oscillation clock signal, and perform initial frequency division processing on the initial oscillation clock signal, to acquire the initial feedback clock signal; wherein, when the phase-locked loop cell is in the initial locked state, the first edge of the initial feedback clock signal is aligned with the first edge of the initial delay-matched clock signal and has the target duty cycle;
the calibration control cell, further configured to, when the phase-locked loop cell is in the initial locked state, perform initial sampling processing on the initial delay-matched clock signal using the initial feedback clock signal, to acquire an initial sampled signal, the initial sampled signal is used to instruct the relationship between the duty cycle of the initial clock signal and the target duty cycle; according to the initial sampled signal, generate the duty cycle selection control signal.

14. A clock duty cycle calibration method, comprising:
performing delay matching processing on the calibration clock signal, to acquire a delay-matched clock signal, the first edge of the delay-matched clock signal is aligned with the first edge of the calibration clock signal, and the delay-matched clock signal has the same duty cycle as the calibration clock signal;
performing a frequency multiplication processing on the calibration clock signal, to acquire the corresponding frequency-multiplied clock signal; the first edge of the frequency-multiplied clock signal is aligned with the first edge of the calibration clock signal, and the frequency of the frequency-multiplied clock signal is a multiple of the frequency of the calibration clock signal;
performing the first phase-locked processing on the frequency-multiplied clock signal, to acquire the first oscillating clock signal; performing the first frequency division processing on the first oscillating clock signal, to acquire the first feedback clock signal; wherein, when the phase-locked loop cell is in the first locked state, the first edge of the first feedback clock signal is aligned with the first edge of the frequency-multiplied clock signal, and the first feedback clock signal has the same frequency as the frequency-multiplied clock signal;
when the phase-locked loop cell is in the first locked state, using the first feedback clock signal to perform a first sampling processing on the delay-matched clock signal, to acquire the first sampled signal; according to the first sampled signal, generate the first calibration control signal;
performing a first duty cycle calibration processing on the input clock signal according to the first calibration control signal, that maintain the duty cycle of the calibration clock signal at the target duty cycle.

15. A clock multiplier circuit, wherein comprising the clock duty cycle calibration circuit of any one of claims 1 to 13.
